# EUROPEAN PATENT SPECIFICATION

(11) **EP 4 379 964 B1**
(45) Date of publication and mention of the grant of the patent: **30.04.2025**
(21) Application number: 23205196.1
(22) Date of filing: 23.10.2023
(51) Int. Cl.: H01R 12/63, H05K 1/18, H01R 12/70

(54) **CONNECTOR ASSEMBLY AND CONNECTING METHOD**
VERBINDERANORDNUNG UND VERBINDUNGSVERFAHREN
ENSEMBLE CONNECTEUR ET PROCÉDÉ DE CONNEXION

(30) Priority: 30.11.2022 JP 2022191896
(43) Date of publication of application: 05.06.2024
(73) Proprietor: Japan Aviation Electronics Industry, Ltd., Tokyo 150-0043 (JP)
(72) Inventor: KIMURA, Akira, Tokyo, 150-0043 (JP)
(74) Representative: Qip Patentanwälte Dr. Kuehn & Partner mbB

(56) References cited:
- EP-A1- 4 379 963
- JP-A- 2004 063 280
- JP-B2- 2 874 405
- US-B1- 6 247 977

## Description

### BACKGROUND OF THE INVENTION

The present invention relates to a connector assembly and a connecting method, particularly to a connector assembly and a connecting method that electrically connect a conductor portion of an electric wire to a flexible conductor exposed on a surface of a sheet type conductive member.

In recent years, attention has been drawn to so-called smart clothes that can obtain user's biological data such as the heart rate and the body temperature only by being worn by the user. Such smart clothes have an electrode disposed at a measurement site and constituted of a flexible conductor, and when a wearable device serving as a measurement device is electrically connected to the electrode, biological data can be transmitted to the wearable device.

The electrode and the wearable device can be interconnected by, for instance, use of a connector connected to the flexible conductor.

However, when the wearable device is situated away from the measurement site, it is necessary to provide an electric path connecting the electrode disposed at the measurement site to the place where the connector is attached, and if such an electric path is formed from a flexible conductor, this causes higher electric resistance and higher cost.

To interconnect an electrode constituted of a flexible conductor and a wearable device by use of an electric wire that has low electric resistance and is inexpensive, it has been desired to develop a small-sized connector connecting the electric wire to the flexible conductor disposed on a garment.

As a connector for connecting an electric wire to a flexible conductor, for instance, JP 2007-214087 A discloses a connector as shown in FIG. 35. This connector includes a first connector 2 connected to an end of a substrate 1 and a second connector 4 attached to tips of electric wires 3, and the electric wires 3 can be connected to a flexible conductor of the substrate 1 by fitting the second connector 4 to the first connector 2.

However, the first connector 2 and the second connector 4 that are separately attached to the end of the substrate 1 and the tips of the electric wires 3 need to be fitted to each other in order to connect the electric wires 3 to the flexible conductor of the substrate 1, and this causes a larger size of a device; and there is a separable connection portion between the first connector 2 and the second connector 4, which impairs the reliability of electric connection.

From JP 2004 063 280 A a connection structure is known which is provided with: conductor exposing parts of the flat wiring material; conductor exposing parts of the flexible printed wiring material; and an overlapping connection means for connecting both exposing parts and to each other. The connection means is so composed as to connect both the exposing parts and with each other by overlaying a folded piece on the outside of the overlapping part of both the exposing parts and formed by superimposing, on the exposing parts with an upper insulating cover member removed, the exposing parts penetrating the folded piece folded back from the conductor tip side of a lower insulating cover member on the exposing part side.

From JP 2 874 405 B2 a wiring connection is known, wherein end sections of circuit conductors of each flat cable mutually wiring-connected are exposed respectively, and the flat cables are inserted so that the exposed sides are faced oppositely into a case body. When a short piece-shaped flat-cable small piece is inserted into the case body together with the pressure-welding fitting section of a cover body 17 and each circuit conductor of the flat cables and the circuit conductors of the flat-cable small piece are brought into contact, the circuit conductors of the flat cables are wired and connected mutually in a mutually crossed shape through the circuit conductors of the flat-cable small piece.

### SUMMARY OF THE INVENTION

The present invention has been made to solve the conventional problem as above and aims at providing a connector assembly that can electrically connect a conductor portion of an electric wire to a flexible conductor exposed on a surface of a sheet type conductive member with high reliability while its size can be reduced.

The present invention also aims at providing a connecting method for electrically connecting a conductor portion of an electric wire to a flexible conductor exposed on a surface of a sheet type conductive member.

A connector assembly according to the present invention comprises:
a sheet type conductive member having a flexible conductor exposed on a surface of the sheet type conductive member;
an electric wire having a conductor portion; and
a connector connecting the conductor portion to the flexible conductor,
wherein the connector includes a first insulator having a first retaining surface and a second insulator having a second retaining surface facing the first retaining surface,
wherein the sheet type conductive member includes a first sheet portion having a retained portion disposed to face the first retaining surface, a second sheet portion joined to the retained portion via a folding-back line and disposed to face the second retaining surface with the second sheet portion being folded back onto the retained portion along the folding-back line, and at least one electric wire inserting hole formed in at least one of the retained portion and the second sheet portion and penetrating the sheet type conductive member,
wherein the flexible conductor is exposed at least on a surface of the retained portion,
wherein the conductor portion of the electric wire is passed through the electric wire inserting hole and disposed between the retained portion and the second sheet portion, and
wherein the first insulator and the second insulator are fixed with each other such that the retained portion and the second sheet portion are superposed on each other and disposed between the first retaining surface and the second retaining surface, whereby the flexible conductor makes contact with and is electrically connected to the conductor portion of the electric wire.

A connecting method according to the present invention is one for connecting a conductor portion of an electric wire to a flexible conductor exposed on a surface of a sheet type conductive member, the method comprising:
passing the conductor portion of the electric wire through at least one electric wire inserting hole formed in at least one of a retained portion and a second sheet portion in the sheet type conductive member having a first sheet portion and the second sheet portion joined to the retained portion of the first sheet portion via a folding-back line, the at least one electric wire inserting hole penetrating the sheet type conductive member,
folding back the second sheet portion onto the retained portion along the folding-back line so that the conductor portion of the electric wire is disposed between the retained portion and the second sheet portion, and
fixing the first insulator and the second insulator with each other with the retained portion and the second sheet portion being sandwiched between a first retaining surface of the first insulator and a second retaining surface of the second insulator, whereby the flexible conductor makes contact with and is electrically connected to the conductor portion of the electric wire.

### BRIEF DESCRIPTION OF THE DRAWINGS

FIG. 1 is a perspective view showing a connector assembly according to Embodiment 1.
FIG. 2 is an assembly view of the connector assembly according to Embodiment 1.
FIG. 3 is a plan view showing a sheet type conductive member used in Embodiment 1.
FIG. 4 is a perspective view showing a state where electric wires are separately passed through electric wire inserting holes of the sheet type conductive member in Embodiment 1.
FIG. 5 is a perspective view showing a state where each of the electric wires is sequentially passed through a pair of electric wire inserting holes of the sheet type conductive member in Embodiment 1.
FIG. 6 is a perspective view showing a state where a second sheet portion of the sheet type conductive member in Embodiment 1 is folded back.
FIG. 7 is a perspective view showing a state where the sheet type conductive member in Embodiment 1 is sandwiched between a first insulator and a second insulator.
FIG. 8 is a partial cross-sectional plan view showing a state where a conductor portion of the electric wire and a flexible conductor make contact with each other in the connector assembly of Embodiment 1.
FIG. 9 is a cross-sectional side view of the connector assembly cut along line A-A of FIG. 8.
FIG. 10 is a cross-sectional side view of the connector assembly cut along line B-B of FIG. 8.
FIG. 11 is a perspective view showing a connector assembly according to Embodiment 2.
FIG. 12 is an assembly view of the connector assembly according to Embodiment 2.
FIG. 13 is a plan view showing a sheet type conductive member used in Embodiment 2.
FIG. 14 is a perspective view showing a state where electric wires are separately passed through electric wire inserting holes of the sheet type conductive member in Embodiment 2.
FIG. 15 is a perspective view showing a state where each of the electric wires is sequentially passed through a pair of electric wire inserting holes of the sheet type conductive member in Embodiment 2.
FIG. 16 is a perspective view showing a state where a second sheet portion of the sheet type conductive member in Embodiment 2 is folded back.
FIG. 17 is a perspective view showing a state where the sheet type conductive member in Embodiment 2 is sandwiched between a first insulator and a second insulator.
FIG. 18 is a partial cross-sectional plan view showing a state where a conductor portion of the electric wire and a flexible conductor make contact with each other in the connector assembly of Embodiment 2.
FIG. 19 is a cross-sectional side view of the connector assembly cut along line C-C of FIG. 18.
FIG. 20 is a cross-sectional side view of the connector assembly cut along line D-D of FIG. 18.
FIG. 21 is a perspective view showing a connector assembly according to Embodiment 3.
FIG. 22 is an assembly view of the connector assembly according to Embodiment 3.
FIG. 23 is a plan view showing a sheet type conductive member used in Embodiment 3.
FIG. 24 is an enlarged view of a main part of FIG. 23.
FIG. 25 is a perspective view showing a state where electric wires are separately passed through electric wire guiding holes of the sheet type conductive member in Embodiment 3.
FIG. 26 is a perspective view showing a state where the electric wires are separately slid to electric wire inserting holes of the sheet type conductive member in Embodiment 3.
FIG. 27 is a perspective view showing a state where a second sheet portion of the sheet type conductive member in Embodiment 3 is folded back.
FIG. 28 is a perspective view showing a state where the sheet type conductive member in Embodiment 3 is sandwiched between a first insulator and a second insulator.
FIG. 29 is a partial cross-sectional plan view showing a state where a conductor portion of the electric wire and a flexible conductor make contact with each other in the connector assembly of Embodiment 3.
FIG. 30 is a cross-sectional side view of the connector assembly cut along line E-E of FIG. 29.
FIG. 31 is a perspective view showing a connector assembly according to Embodiment 4.
FIG. 32 is an assembly view of the connector assembly according to Embodiment 4.
FIG. 33 is a cross-sectional side view of the connector assembly of Embodiment 4.
FIG. 34 is an assembly view of a connector assembly according a modification of Embodiment 4.

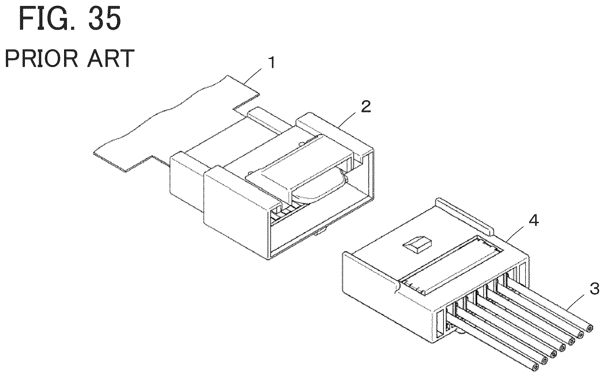

FIG. 35 is a perspective view showing a conventional connector.

### DETAILED DESCRIPTION OF THE INVENTION

Embodiments of the present invention are described below based on the accompanying drawings.

### Embodiment 1

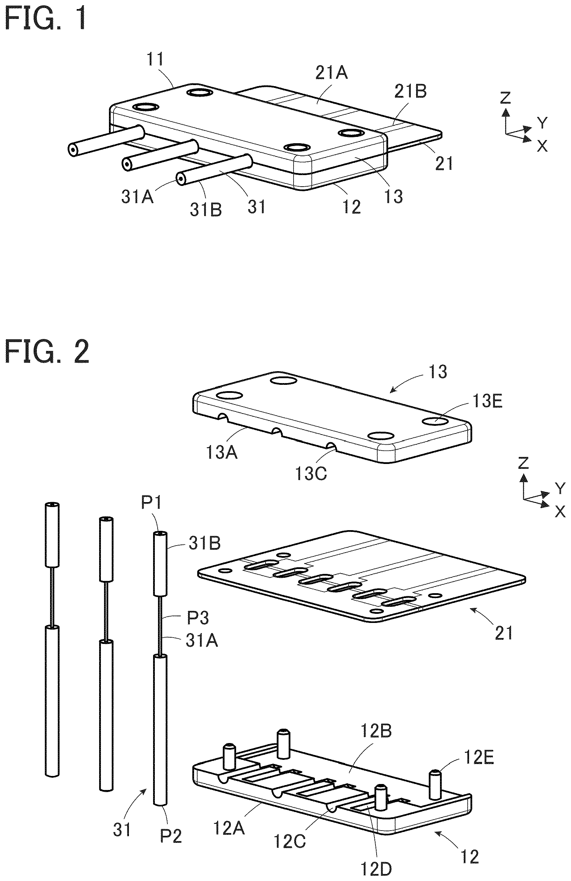

FIG. 1 shows a connector assembly according to Embodiment 1. The connector assembly is obtained by connecting conductor portions 31A of a plurality of coated electric wires 31 to a sheet type conductive member 21 by means of a connector 11.

The connector 11 includes a first insulator 12 and a second insulator 13 each made of an insulating resin material.

The sheet type conductive member 21 is obtained by forming a plurality of flexible conductors 21B on a surface of a sheet type insulating base 21A. The flexible conductors 21B are aligned in a predetermined alignment direction, separately form linearly extending patterns, and are exposed on a surface of the sheet type conductive member 21.

The coated electric wires 31 are aligned in the predetermined alignment direction as with the flexible conductors 21B of the sheet type conductive member 21, and each extend in parallel to the surface of the sheet type conductive member 21 and in a direction perpendicular to the alignment direction. Each coated electric wire 31 has a structure in which an outer periphery of the conductor portion 31A is covered with an insulating coating portion 31B. With the connector 11, the conductor portions 31A of the covered electric wires 31 are electrically connected to the flexible conductors 21B exposed on the surface of the sheet type conductive member 21. The conductor portion 31A of the coated electric wire 31 may be either a so-called solid wire constituted of one conductor or a so-called stranded wire constituted of plural conductors being stranded.

For convenience, the sheet type conductive member 21 is defined as extending along an XY plane, the predetermined alignment direction of the flexible conductors 21B and the coated electric wires 31 is referred to as "X direction," the direction in which each coated electric wire 31 extends toward the connector 11 is referred to as "+Y direction," and the direction orthogonal to an XY plane is referred to as "Z direction."

FIG. 2 shows an assembly view of the connector assembly according to Embodiment 1. The sheet type conductive member 21 is disposed on the +Z direction side of the first insulator 12, and the second insulator 13 is disposed on the +Z direction side of the sheet type conductive member 21.

In addition, the coated electric wires 31 are each disposed in such a position as to extend in the Z direction on the -Y direction side of the sheet type conductive member 21.

The first insulator 12 includes a flat plate portion 12A of rectangular shape extending along an XY plane, and a first retaining surface 12B of planar shape recessed in the -Z direction and facing in the +Z direction is formed at a +Y direction-side portion of the flat plate portion 12A. In addition, electric wire accommodating grooves 12C and 12D are formed on a -Y direction-side portion of the flat plate portion 12A, the electric wire accommodating grooves 12C extending in the Y direction from the first retaining surface 12B to a -Y directional end of the flat plate portion 12A, the electric wire accommodating grooves 12D being each disposed adjacent to the corresponding electric wire accommodating groove 12C on the +X direction side of the electric wire accommodating groove 12C, extending in the Y direction from the first retaining surface 12B, and terminating in front of the -Y directional end of the flat plate portion 12A.

These electric wire accommodating grooves 12C and 12D are opened toward the +Z direction and each have a groove width and a groove depth that allow the insulating coating portion 31B of the coated electric wire 31 to be accommodated in the grooves 12C and 12D. The adjacent electric wire accommodating grooves 12C and 12D form a pair, and a plurality of the pairs of electric wire accommodating grooves 12C and 12D corresponding to the coated electric wires 31 are formed in the flat plate portion 12A.

Further, the flat plate portion 12A is provided with a plurality of bosses 12E projecting in the +Z direction.

The second insulator 13 has a flat plate portion 13A of rectangular shape extending along an XY plane, and as with the first insulator 12, a second retaining surface of planar shape (not shown) recessed in the +Z direction and facing in the -Z direction is formed at a +Y direction-side portion of the flat plate portion 13A. In addition, electric wire accommodating grooves 13C and electric wire accommodating grooves not shown are formed at a -Y direction-side portion and in a surface, facing in the -Z direction, of the flat plate portion 31A, the electric wire accommodating grooves 13C extending in the Y direction from the second retaining surface to a -Y directional end of the flat plate portion 13A, the electric wire accommodating grooves not shown being each disposed adjacent to the corresponding electric wire accommodating groove 13C on the +X direction side of the electric wire accommodating groove 13C, extending in the Y direction from the second retaining surface, and terminating in front of the -Y directional end of the flat plate portion 13A.

These electric wire accommodating grooves 13C and electric wire accommodating grooves not shown correspond to the electric wire accommodating grooves 12C and 12D of the first insulator 12, are opened toward the -Z direction, and each have a groove width and a groove depth that allow the insulating coating portion 31B of the coated electric wire 31 to be accommodated in the groove 13C and the groove not shown.

Further, the flat plate portion 13A is provided with a plurality of fixing holes 13E penetrating the flat plate portion 13A in the Z direction. The fixing holes 13E separately correspond to the bosses 12E of the first insulator 12.

The coated electric wires 31 in assembling the connector assembly are each disposed in such a position as to extend in the Z direction such that a tip portion P1 faces in the +Z direction and that a base end portion P2 faces in the -Z direction. In addition, a conductor exposed portion P3, in which the conductor portion 31A is exposed over a predetermined Z directional length by removing the insulating coating portion 31B, is formed at a position away from the tip portion P1 of each coated electric wire 31 by a predetermined distance in the -Z direction.

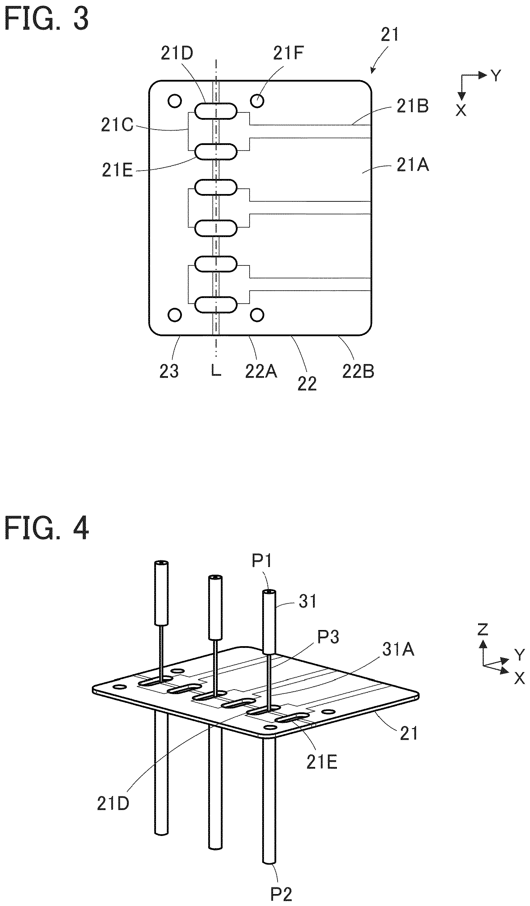

As shown in FIG. 3, the sheet type conductive member 21 includes a first sheet portion 22 and a second sheet portion 23 disposed on the -Y direction side of the first sheet portion 22. A retained portion 22A is disposed at a -Y direction-side portion of the first sheet portion 22, and an extension portion 22B extending toward the +Y direction is disposed on the +Y direction side of the retained portion 22A. The second sheet portion 23 is joined to the retained portion 22A of the first sheet portion 22 via a folding-back line L extending in the X direction. The second sheet portion 23, the retained portion 22A, and the extension portion 22B are integrally formed continuously in the Y direction.

The flexible conductors 21B exposed on the surface of the sheet type conductive member 21 on the +Z direction side are each disposed continuously from the second sheet portion 23 to the retained portion 22A and the extension portion 22B of the first sheet portion 22 beyond the folding-back line L. Each flexible conductor 21B has an electric wire connecting region 21C of substantially rectangular shape at a position overlapping the folding-back line L, and a pair of electric wire inserting holes 21D and 21E penetrating the sheet type conductive member 21 are separately formed on opposite sides in the X direction of the electric wire connecting region 21C on the folding-back line L. The pair of electric wire inserting holes 21D and 21E are each formed from a long hole that is sized so as to allow the insulating coating portion 31B of the coated electric wire 31 to pass through it. In addition, the pair of electric wire inserting holes 21D and 21E are separately situated to be in contact with the electric wire connecting region 21C on the opposite sides in the X direction of the electric wire connecting region 21C, and the flexible conductor 21B forming the electric wire connecting region 21C is disposed between the pair of electric wire inserting holes 21D and 21E.

A plurality of the pairs of electric wire inserting holes 21D and 21E as above are formed in the sheet type conductive member 21 to correspond to the coated electric wires 31.

Further, a plurality of through-holes 21F corresponding to the plurality of bosses 12E of the first insulator 12 are formed in the retained portion 22A and the second sheet portion 23 of the sheet type conductive member 21. One through-hole 21F formed in the retained portion 22A and another through hole 21F formed in the second sheet portion 23 are arranged symmetrically with respect to the folding-back line L.

When the connector assembly is assembled, first, as shown in FIG. 4, each of the coated electric wires 31 is passed through the electric wire inserting hole 21D that is one of the corresponding pair of electric wire inserting holes 21D and 21E of the sheet type conductive member 21. At this time, the coated electric wire 31 is disposed such that a part thereof from the conductor exposed portion P3 to the tip portion P1 is situated on the +Z direction side of the sheet type conductive member 21 and that a part thereof on the base end portion P2 side of the conductor exposed portion P3 is situated on the -Z direction side of the sheet type conductive member 21.

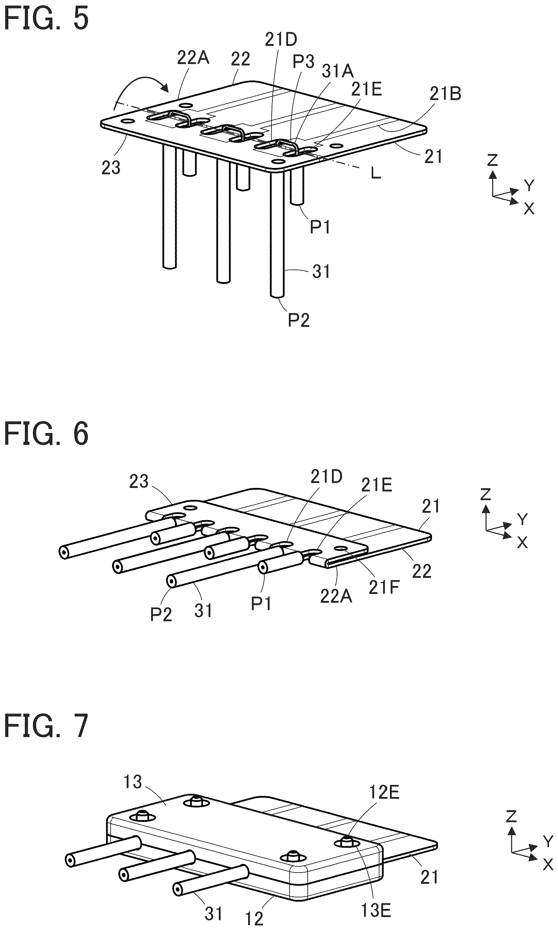

Next, the conductor exposed portion P3 is bent, and the tip portion P1 of each of the coated electric wires 31 is passed through the electric wire inserting hole 21E that is the other of the corresponding pair of the electric wire inserting holes 21D and 21E from the +Z direction. When each of the coated electric wires 31 is sequentially passed through the pair of electric wire inserting holes 21D and 21E in this manner, as shown in FIG. 5, the tip portion P1 of each of the coated electric wires 31 is situated on the -Z direction side of the sheet type conductive member 21, and the conductor portion 31A exposed at the conductor exposed portion P3 is situated between the pair of electric wire inserting holes 21D and 21E on the surface of the sheet type conductive member 21 on the +Z direction side.

By folding back, in this state, the second sheet portion 23 of the sheet type conductive member 21 along the folding-back line L extending in the X direction that is the alignment direction of the coated electric wires 31 and the flexible conductors 21B, the second sheet portion 23 is rotated by 180 degrees around the folding-back line L so as to be superposed on the retained portion 22A of the first sheet portion 22 as shown in FIG. 6. At this time, with folding back of the second sheet portion 23, the coated electric wires 31 passed through the plurality of pairs of electric wire inserting holes 21D and 21E are rotated by 90 degrees around the folding-back line L, and the tip portion P1 and the base end portion P2 of each of the coated electric wires 31 extend from the sheet type conductive member 21 toward the -Y direction.

Since the through-holes 21F separately formed in the retained portion 22A and the second sheet portion 23 are arranged symmetrically with respect to the folding-back line L, when the second sheet portion 23 is folded back around the folding-back line L, the through-hole 21F formed in the second sheet portion 23 is superposed on the through-hole 21F formed in the retained portion 22A.

Then, with the bosses 12E of the first insulator 12 being passed through the through-holes 21F of the sheet type conductive member 21 from the -Z direction and further passed through the fixing holes 13E of the second insulator 13, the sheet type conductive member 21 is sandwiched between the first insulator 12 and the second insulator 13 as shown in FIG. 7. Consequently, the retained portion 22A of the first sheet portion 22 of the sheet type conductive member 21 faces the first retaining surface 12B of the first insulator 12, and the second sheet portion 23 superposed on the retained portion 22A faces the second retaining surface of the second insulator 13.

Tips of the bosses 12E projecting on the +Z direction side of the first insulator 13 are then thermally deformed, whereby the first insulator 12 and the second insulator 13 are fixed to each other to form the connector 11. Thus, the assembling operation of the connector assembly shown in FIG. 1 is completed.

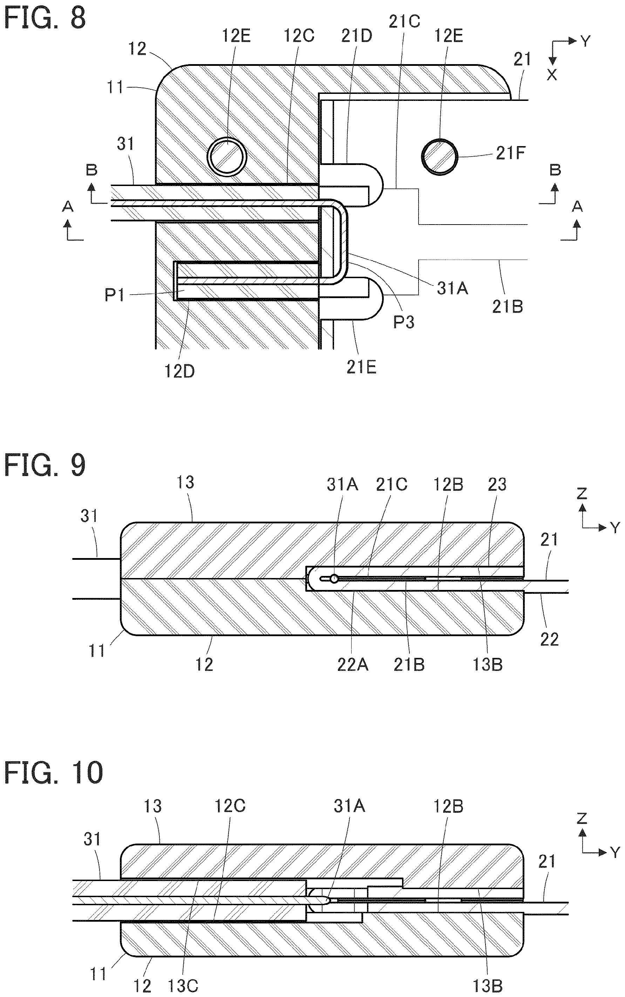

FIG. 8 shows the inside of the connector assembly. Since the electric wire connecting region 21C of the flexible conductor 21B is formed between the pair of the electric wire inserting holes 21D and 21E, with folding back of the second sheet portion 23, the flexible conductor 21B forming the electric wire connecting region 21C is folded in two parts, and the conductor portion 31A exposed at the conductor exposed portion P3 situated between the pair of electric wire inserting holes 21D and 21E is sandwiched between the two parts of the flexible conductor 21B thus folded as shown in FIG. 9. In this manner, the flexible conductor 21B makes contact with the conductor portion 31A of the coated electric wire 31 with predetermined contact pressure and is electrically connected to the conductor portion 31A.

Similarly, the plurality of flexible conductors 21B are electrically connected separately to the conductor portions 31A of the plurality of coated electric wires 31.

As shown in FIG. 9, the retained portion 22A of the first sheet portion 22 and the second sheet portion 23 of the sheet type conductive member 21 being superposed on each other are sandwiched between the first retaining surface 12B of the first insulator 12 and the second retaining surface 13B of the second insulator 13.

In addition, as shown FIG. 8, the tip portion P1 of the coated electric wire 31 projects in the -Y direction from the electric wire inserting hole 21E of the sheet type conductive member 21 and is accommodated in the electric wire accommodating groove 12D of the first insulator 12 and the electric wire accommodating groove not shown of the second insulator 13 in the connector 11.

On the other hand, the part of the coated electric wire 31 on the base end portion P2 side projects in the -Y direction from the electric wire inserting hole 21D of the sheet type conductive member 21 and is accommodated in the electric wire accommodating groove 12C of the first insulator 12 and the electric wire accommodating groove 13C of the second insulator 13 and drawn from the connector 11 in the -Y direction as shown in FIG. 10.

According to Embodiment 1, the conductor portion 31A is sandwiched between the two parts of the flexible conductor 21B thus folded, thereby enabling to achieve a connector assembly that is small, specifically, thin, while electrically connecting the conductor portion 31A of the coated electric wire 31 to the flexible conductor 21B exposed on the surface of the sheet type conductive member 21 with high reliability.

### Embodiment 2

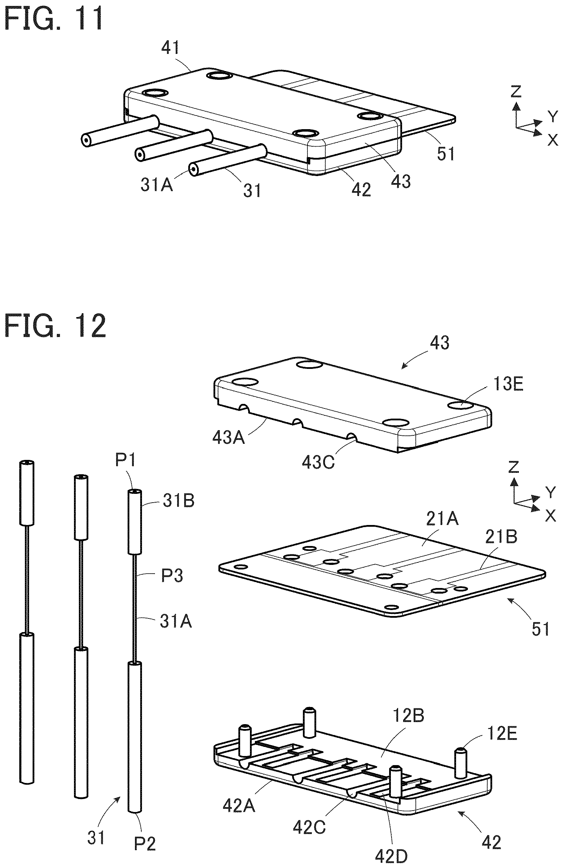

FIG. 11 shows a connector assembly according to Embodiment 2. The connector assembly is obtained by connecting conductor portions 31A of a plurality of coated electric wires 31 to a sheet type conductive member 51 by means of a connector 41.

The connector 41 includes a first insulator 42 and a second insulator 43 each made of an insulating resin material.

FIG. 12 shows an assembly view of the connector assembly according to Embodiment 2.

The first insulator 42 has the same configuration as that of the first insulator 12 used in Embodiment 1. That is, the second insulator 42 includes a flat plate portion 42A of rectangular shape extending along an XY plane, and the first retaining surface 12B facing in the +Z direction is formed at a +Y direction-side portion of the flat plate portion 42A. A plurality of electric wire accommodating grooves 42C and 42D extending to the inside of the first retaining surface 12B are formed at a -Y direction-side portion of the flat plate portion 42A as with the electric wire accommodating grooves 12C and 12D of the first insulator 12. The electric wire accommodating grooves 42C and 42D each have a groove width and a groove depth that allow the insulating coating portion 31B of the coated electric wire 31 to be accommodated in the grooves 42C and 42D.

In addition, the flat plate portion 42A is provided with the plurality of bosses 12E.

The second insulator 43 has the same configuration as that of the second insulator 13 used in Embodiment 1. That is, the second insulator 43 includes a flat plate portion 43A of rectangular shape extending along an XY plane, and a second retaining surface (not shown) facing in the -Z direction is formed at a +Y direction-side portion of the flat plate portion 43A. In addition, a plurality of electric wire accommodating grooves 43C and a plurality of electric wire accommodating grooves (not shown) corresponding to the electric wire accommodating grooves 42C and 42D of the first insulator 42 are formed at a -Y direction-side portion and in the surface, facing in the -Z direction, of the flat plate portion 43A. The electric wire accommodating grooves 43C and the electric wire accommodating groove not shown each have a groove width and a groove depth that allow the insulating coating portion 31B of the coated electric wire 31 to be accommodated in the groove 43C and the groove not shown.

In addition, the flat plate portion 43A is provided with the plurality of fixing holes 13E.

The sheet type conductive member 51 is obtained by forming the plurality of flexible conductors 21B on the surface of the sheet type insulating base 21A as with the sheet type conductive member 21 in Embodiment 1.

The coated electric wires 31 herein have the same configuration as that of the coated electric wires 31 used in Embodiment 1 except that the coated electric wires 31 herein each have the conductor exposed portion P3 longer in the Z direction than the conductor exposed portion P3 in the coated electric wire 31 used in Embodiment 1.

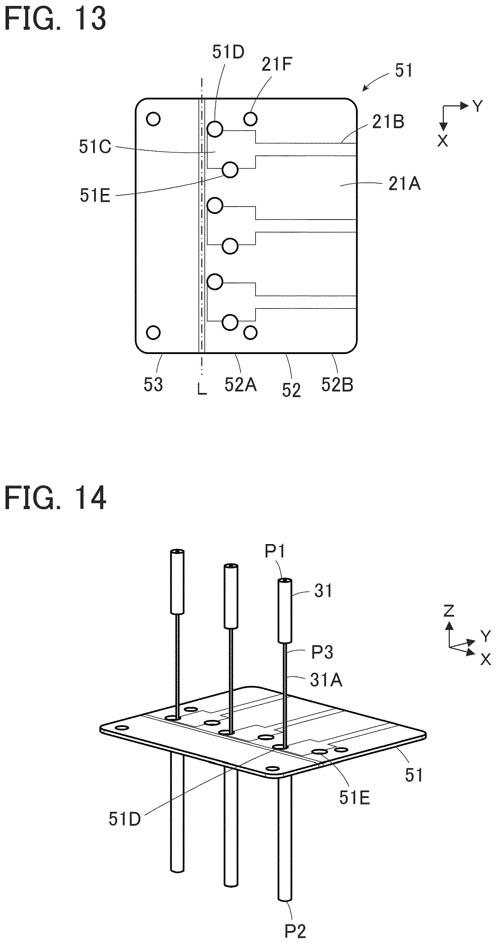

As shown in FIG. 13, the sheet type conductive member 51 includes a first sheet portion 52 and a second sheet portion 53 disposed on the -Y direction side of the first sheet portion 52, a retained portion 52A is disposed at a -Y direction-side portion of the first sheet portion 52, and an extension portion 52B extending toward the +Y direction is formed on the +Y direction side of the retained portion 52A. The second sheet portion 53 is joined to the retained portion 52A of the first sheet portion 52 via the folding-back line L extending in the X direction.

The flexible conductors 21B are formed only on a surface of the first sheet portion 52 on the +Z direction side and are not formed in the second sheet portion 53.

Each flexible conductor 21B extends in the Y direction and is provided at its -Y directional end with an electric wire connecting region 51C of substantially rectangular shape disposed at the retained portion 52A. A pair of electric wire inserting holes 51D and 51E penetrating the sheet type conductive member 51 are formed on opposite sides in the X direction of the electric wire connecting region 51C near the folding-back line L. The pair of electric wire inserting holes 51D and 51E are disposed at positions inclined with respect to the folding-back line L, i.e., Y directional positions different from each other, and are each formed from a round hole that is sized so as to allow the insulating coating portion 31B of the coated electric wire 31 to pass through it.

The pair of electric wire inserting holes 51D and 51E are each sized to allow the insulating coating portion 31B of the coated electric wire 31 to pass through it. In addition, the pair of electric wire inserting holes 51D and 51E are situated to be in contact with the electric wire connecting region 51C on the opposite sides in the X direction of the electric wire connecting region 51C, and the flexible conductor 21B forming the electric wire connecting region 51C is disposed between the pair of electric wire inserting holes 51D and 51E.

A plurality of the pairs of electric wire inserting holes 51D and 51E as above are formed in the sheet type conductive member 51 to correspond to the coated electric wires 31.

Further, the retained portion 52A and the second sheet portion 53 of the sheet type conducive member 51 are provided with the plurality of through-holes 21F.

When the connector assembly is assembled, first, as shown in FIG. 14, each of the coated electric wires 31 is passed through the electric wire inserting hole 51D of the corresponding pair of the electric wire inserting holes 51D and 51E of the sheet type conductive member 51. At this time, the coated electric wire 31 is disposed such that a part thereof from the conductor exposed portion P3 to the tip portion P1 is situated on the +Z direction side of the sheet type conductive member 51 and that a part thereof on the base end portion P2 side of the conductor exposed portion P3 is situated on the -Z direction side of the sheet type conductive member 51.

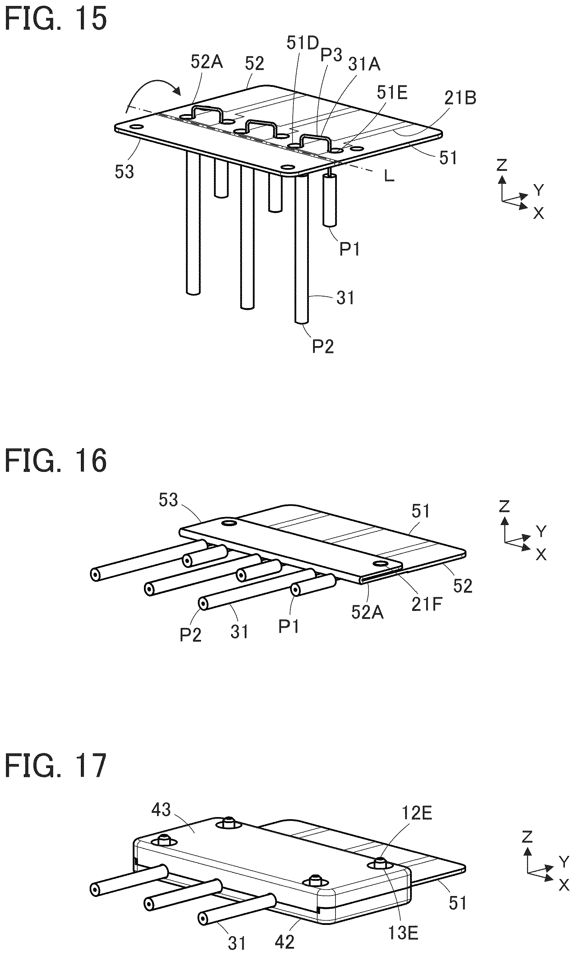

Next, the conductor exposed portion P3 is bent, and the tip portion P1 of each of the coated electric wires 31 is passed through the electric wire inserting hole 51E that is the other of the corresponding pair of electric wire inserting holes 51D and 51E from the +Z direction. When each of the coated electric wires 31 is sequentially passed through the corresponding pair of electric wire inserting holes 51D and 51E in this manner, as shown in FIG. 15, the tip portion P1 of each of the coated electric wires 31 is situated on the -Z direction side of the sheet type conductive member 51, and the conductor portion 31A exposed at the conductor exposed portion P3 is situated between the pair of electric wire inserting holes 51D and 51E on the surface of the sheet type conductive member 51 on the +Z direction side.

By folding back, in this state, the second sheet portion 53 of the sheet type conductive member 51 along the folding-back line L extending in X direction, as shown in FIG. 16, the second sheet portion 53 is rotated by 180 degrees around the folding-back line L so as to be superposed on the retained portion 52A of the first sheet portion 52. At this time, with folding back of the second sheet portion 53, the coated electric wires 31 passed through the plurality of pairs of electric wire inserting holes 51D and 51E are rotated by 90 degrees around the folding-back line L, and the tip portion P1 and the base end portion P2 of each of the coated electric wires 31 extend from the sheet type conductive member 51 toward the -Y direction.

Thereafter, with the bosses 12E of the first insulator 42 being separately passed through the through-holes 21F of the sheet type conductive member 51 from the -Z direction and further passed through the fixing holes 13E of the second insulator 43, the sheet type conductive member 51 is sandwiched between the first insulator 42 and the second insulator 43 as shown in FIG. 17.

Tips of the bosses 12E projecting on the +Z direction side of the second insulator 43 are then thermally deformed, whereby the first insulator 42 and the second insulator 43 are fixed to each other to form the connector 41. Thus, the assembling operation of the connector assembly shown in FIG. 11 is completed.

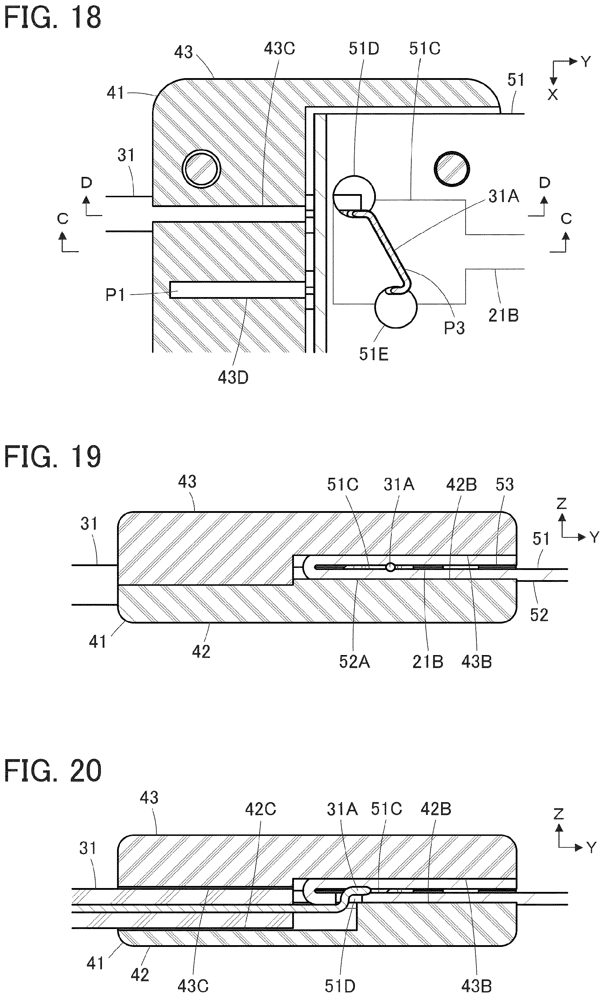

FIG. 18 shows the inside of the connector assembly. Since the electric wire connecting region 51C of the flexible conductor 21B is formed between the pair of electric wire inserting holes 51D and 51E, the conductor portion 31A exposed at the conductor exposed portion P3 situated between the pair of electric wire inserting holes 51D and 51E is disposed on the electric wire connecting region 51C, and as shown in FIG. 19, with folding back of the second sheet portion 53, the retained portion 52A of the first sheet portion 52 and the second sheet portion 53 being superposed on each other are sandwiched between the first retaining surface 42B of the first insulator 42 and the second retaining surface 43B of the second insulator 43. In this manner, the flexible conductor 21B forming the electric wire connecting region 51C makes contact with the conductor portion 31A of the coated electric wire 31 with predetermined contact pressure and is electrically connected to the conductor portion 31A.

Similarly, the plurality of flexible conductors 21B are electrically connected separately to the conductor portions 31A of the plurality of coated electric wires 31.

In addition, as shown in FIG. 18, the tip portion P1 of the coated electric wire 31 projects in the -Y direction from the electric wire inserting hole 51E of the sheet type conductive member 51 and is accommodated in the electric wire accommodating groove 42D of the first insulator 42 and the electric wire accommodating groove 43D of the second insulator 43 in the connector 41.

On the other hand, the part of the coated electric wire 31 on the base end portion P2 side projects in the -Y direction from the electric wire inserting hole 51D of the sheet type conductive member 51 and is accommodated in the electric wire accommodating groove 42C of the first insulator 42 and the electric wire accommodating groove 43C of the second insulator 43 and drawn from the connector 41 in the -Y direction as shown in FIG. 20.

Also in Embodiment 2, the conductor portion 31A exposed at the conductor exposed portion P3 of the coated electric wire 31 makes contact with the electric wire connecting region 51C of the corresponding flexible conductor 21B, thereby enabling to achieve a connector assembly that is small, specifically, thin, while electrically connecting the conductor portion 31A of the coated electric wire 31 to the flexible conductor 21B exposed on the surface of the sheet type conductive member 51 with high reliability.

In addition, since the pair of electric wire inserting holes 51D and 51E of the sheet type conductive member 51 are disposed at the Y directional positions different from each other, the conductor portion 31A situated between the electric wire inserting holes 51D and 51E makes contact with the flexible conductor 21B over a distance longer than that in Embodiment 1, thereby improving the reliability of electrical connection.

Further, in each of the plurality of pairs of the electric wire inserting holes 51D and 51E of the sheet type conductive member 51, the electric wire inserting holes 51D and 51E are disposed at the positions inclined with respect to the folding-back line L, so that the conductor portions 31A of the adjacent coated electric wires 31 are disposed with a distance therebetween in the Y direction, whereby short-circuit between the conductor portions 31A can be effectively prevented. In addition, the alignment pitch in the X direction of the coated electric wires 31 can also be narrowed.

### Embodiment 3

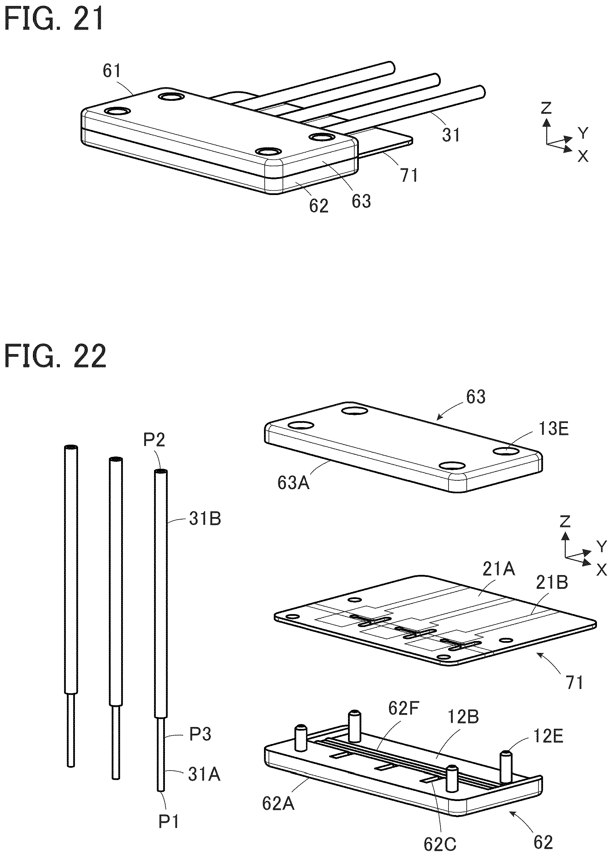

FIG. 21 shows a connector assembly according to Embodiment 3. The connector assembly is obtained by connecting conductor portions 31A of a plurality of coated electric wires 31 to a sheet type conductive member 71 by means of a connector 61.

The connector 61 includes a first insulator 62 and a second insulator 63 each made of an insulating resin material.

FIG. 22 shows an assembly view of the connector assembly according to Embodiment 3.

As with the first insulator 12 used in Embodiment 1, the first insulator 62 includes a flat plate portion 62A of rectangular shape extending along an XY plane, and the first retaining surface 12B facing in the +Z direction is formed at a +Y direction-side portion of the flat plate portion 62A. A plurality of electric wire accommodating grooves 62C are formed at a -Y direction-side portion of the flat plate portion 62A to extend in the Y direction from the first retaining surface 12B and terminate in front of a -Y directional end of the flat plate portion 62A. The electric wire accommodating grooves 62C each have a groove width and a groove depth that allow the conductor portion 31A of the coated electric wire 31 to be accommodated in the groove 62C.

In addition, the flat plate portion 62A is provided with the plurality of bosses 12E.

Further, a plurality of ribs 62F are formed on the first retaining surface 12B to extend in the X direction and project in the +Z direction.

As with the second insulator 13 used in Embodiment 1, the second insulator 63 includes a flat plate portion 63A of rectangular shape extending along an XY plane, and a second retaining surface (not shown) facing in the -Z direction is formed at a +Y direction-side portion of the flat plate portion 63A. In addition, a plurality of electric wire accommodating grooves (not shown) corresponding to the plurality of electric wire accommodating grooves 62C of the first insulator 62 are formed at a -Y direction-side portion and in a surface, facing in the -Z direction, of the flat plate portion 63A. These electric wire accommodating grooves not shown each have a groove width and a groove depth that allow the conductor portion 31A of the coated electric wire 31 to be accommodated in the groove not shown.

In addition, the flat plate portion 63A is provided with the plurality of fixing holes 13E.

Further, ribs (not shown) are formed on the second retaining surface to extend in the X direction and project in the -Z direction.

The sheet type conductive member 71 is obtained by forming the plurality of flexible conductors 21B on the surface of the sheet type insulating base 21A as with the sheet type conductive member 21 in Embodiment 1.

The coated electric wires 31 in assembling the connector assembly are each disposed in such a position as to extend in the Z direction such that the tip portion P1 faces in the -Z direction and that the base end portion P2 faces in the +Z direction. In addition, the conductor exposed portion P3 is formed to extend from the tip portion P1 of each of the coated electric wires 31 in the +Z direction over a predetermined Z directional length. At the conductor exposed portion P3, the insulating coating portion 31B is removed so that the conductor portion 31A is exposed.

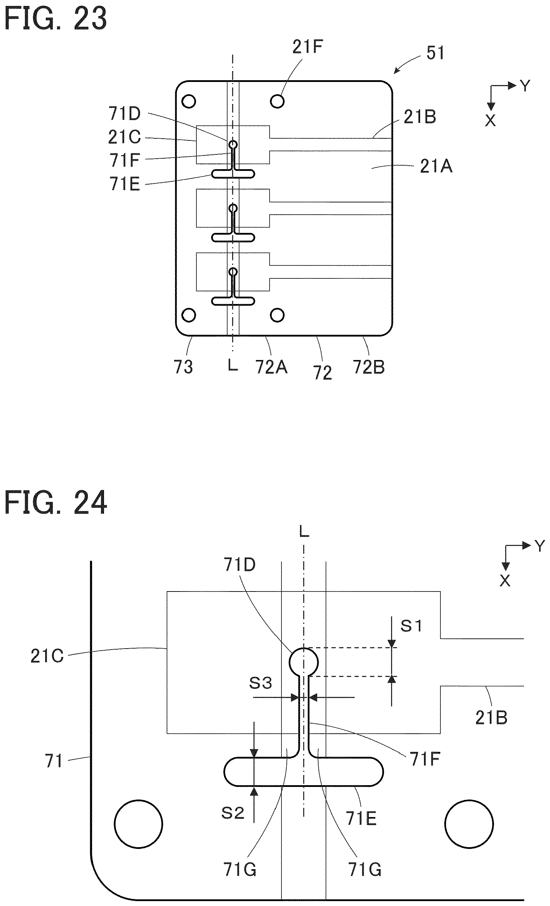

As shown in FIG. 23, the sheet type conductive member 71 includes a first sheet portion 72 and a second sheet portion 73 disposed on the -Y direction side of the first sheet portion 72, a retained portion 72A is disposed in a -Y direction-side portion of the first sheet portion 72, and an extension portion 72B is formed on the +Y direction side of the retained portion 72A to extend toward the +Y direction. The second sheet portion 73 is joined to the retained portion 72A of the first sheet portion 72 via the folding-back line L extending in the X direction.

The flexible conductors 21B are each disposed continuously from the second sheet portion 73 to the retained portion 72A and the extension portion 72B of the first sheet portion 72 beyond the folding-back line L.

Each flexible conductor 21B has the electric wire connecting region 21C of substantially rectangular shape at a position overlapping the folding-back line L, and one electric wire inserting hole 71D penetrating the sheet type conductive member 71 is formed at a center part of the electric wire connecting region 21C situated on the folding-back line L.

In addition, one electric wire guiding hole 71E is formed on the +X direction side of the electric wire connecting region 21C to penetrate the sheet type conductive member 71. The electric wire guiding hole 71E extends in the Y direction from the second sheet portion 73 to the retained portion 72A beyond the folding-back line L.

Further, a slit type communication opening portion 71F penetrating the sheet type conductive member 71 is formed between the electric wire inserting hole 71D and the electric wire guiding hole 71E such that the electric wire inserting hole 71D and the electric wire guiding hole 71E communicate with each other in the X direction along the folding-back line L.

As shown in FIG. 24, the electric wire inserting hole 71D is formed from a round hole having a size corresponding to the diameter of the conductor portion 31A of the coated electric wire 31, specifically, a diameter S1 slightly larger than the diameter of the conductor portion 31A. The electric wire guiding hole 71E is formed from a long hole having a width S2 substantially equal to the diameter S1 of the electric wire inserting hole 71D. The communication opening portion 71F has an opening width S3 having a dimension smaller than the diameter of the conductor portion 31A of the coated electric wire 31.

The communication opening portion 71F is connected to the electric wire guiding hole 71E, whereby a T-shaped opening is formed in the sheet type conductive member 71 so as to be in contact with a pair of corner portions 71G constituted of the sheet type conductive member 71.

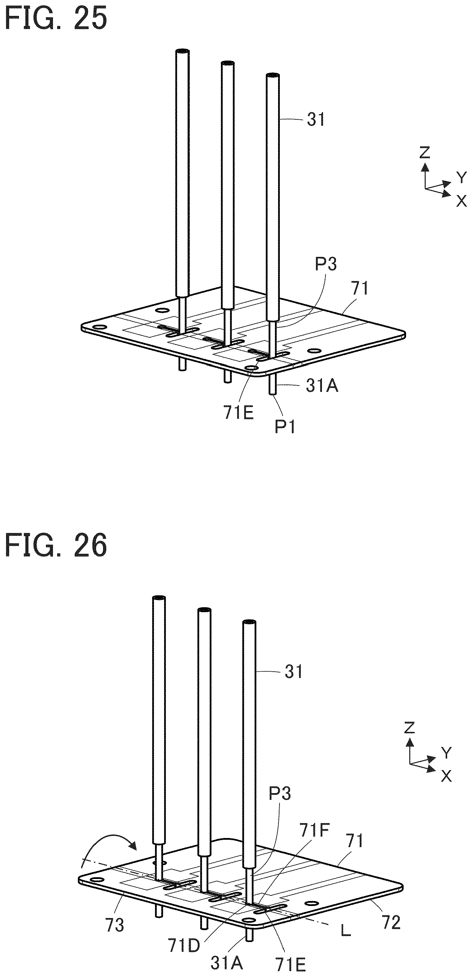

When the connector assembly is assembled, first, as shown in FIG. 25, the conductor portion 31A of the conductor exposed portion P3 formed at the tip portion P1 of each of the coated electric wires 31 is passed through the corresponding electric wire guiding hole 71E of the sheet type conductive member 71 from the +Z direction. At this time, the conductor portion 31A is passed through the electric wire guiding hole 71E such that -Z and +Z direction-side portions of the conductor exposed portion P3 are situated on the -Z and +Z direction sides of the sheet type conductive member 71, respectively.

Next, as shown in FIG. 26, each of the coated electric wires 31 is slid in the -X direction relatively to the sheet type conductive member 71 along the corresponding communication opening portion 71F, whereby the conductor portion 31A exposed at the conductor exposed portion P3 of each of the coated electric wires 31 is passed through the corresponding electric wire inserting hole 71D.

At this time, while the communicating opening hole 71F has the opening width S3 having the dimension smaller than the diameter of the conductor portion 31A, part of the sheet type conductive member 71 around the communicating opening hole 71E is elastically bent, whereby the conductive portion 31A can be relatively slid to the electric wire inserting hole 71D.

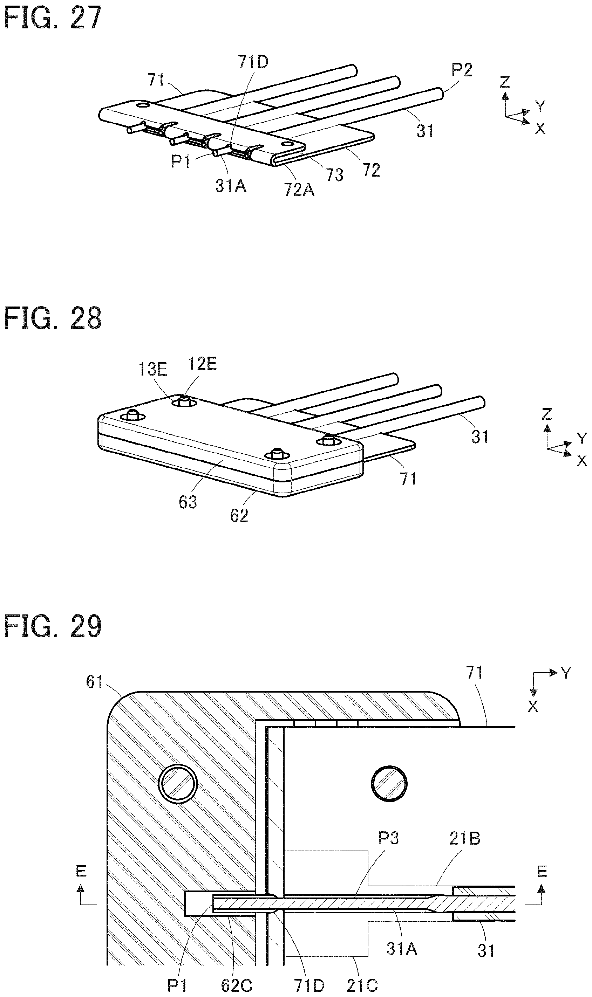

By folding back, in this state, the second sheet portion 73 of the sheet type conductive member 71 along the folding-back line L extending in the X direction, the second sheet portion 73 is rotated by 180 degrees around the folding-back line L so as to be superposed on the retained portion 72A of the first sheet portion 72 as shown in FIG. 27.

With folding back of the second sheet portion 73, the coated electric wires 31 having the conductor portions 31A passed through the electric wire inserting holes 71D are rotated by 90 degrees around the folding-back line L, the tip portion P1 of each of the coated electric wires 31 projects from the sheet type conductive member 71 toward the -Y direction, and the base end portion P2 extends from the sheet type conductive member 71 toward the +Y direction.

Thereafter, with the bosses 12E of the first insulator 62 being separately passed through the through-holes 21F of the sheet type conductive member 71 from the -Z direction and further passed through the fixing holes 13E of the second insulator 63, the sheet type conductive member 71 is sandwiched between the first insulator 62 and the second insulator 63 as shown in FIG. 28.

Tips of the bosses 12E projecting on the +Z direction side of the second insulator 63 are then thermally deformed, whereby the first insulator 62 and the second insulator 63 are fixed to each other to form the connector 61. Thus, the assembling operation of the connector assembly shown in FIG. 21 is completed.

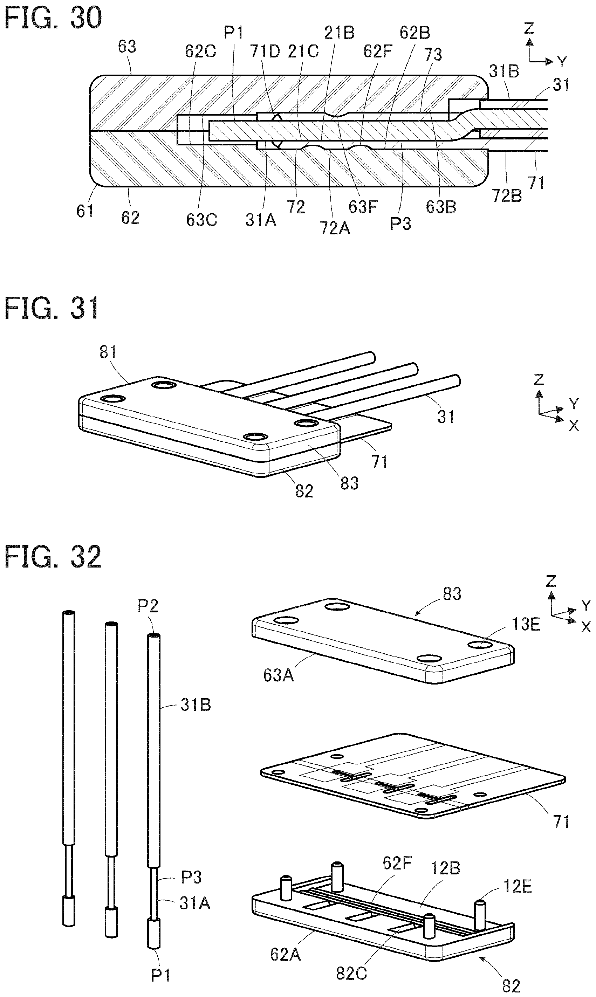

FIG. 29 shows the inside of the connector assembly. Since the flexible conductor 21B has the electric wire connecting region 21C of substantially rectangular shape at the position overlapping the folding-back line L, with the second sheet portion 23 being folded back, the flexible conductor 21B forming the electric wire connecting region 21C is folded in two parts, and the conductor portion 31A exposed at the conductor exposed portion P3 of the coated electric wire 31 passed through the electric wire inserting hole 71D is sandwiched between the two parts of the flexible conductor 21B thus folded as shown in FIG. 30. In this manner, the flexible conductor 21B forming the electric wire connecting region 21C makes contact with the conductor portion 31A of the coated electric wire 31 with predetermined contact pressure and is electrically connected to the conductor portion 31A.

Similarly, the plurality of flexible conductors 21B are electrically connected separately to the conductor portions 31A of the plurality of coated electric wires 31.

The retained portion 72A of the first sheet portion 72 and the second sheet portion 73 of the sheet type conductive member 71 being superposed on each other are sandwiched between the first retaining surface 62B of the first insulator 62 and the second retaining surface 63B of the second insulator 63, and the flexible conductor 21B forming the electric wire connecting region 21C is tightly attached to the conductor portion 31A by means of the ribs 62F formed on the first retaining surface 62B and the ribs 63F formed on the second retaining surface 63B. This improves the reliability of electric connection between the flexible conductor 21B and the conductor portion 31A.

In addition, the conductor portion 31A exposed at the tip portion P1 of the coated electric wire 31 projecting from the sheet type conductive member 71 toward the -Y direction is accommodated in the electric wire accommodating groove 62C of the first insulator 62 and the electric wire accommodating groove 63C of the second insulator 63 in the connector 61.

On the other hand, a part of the coated electric wire 31 on the base end portion P2 side along with the sheet type conductive member 71 is drawn from the connector 61 in the +Y direction. At this time, as shown in FIG. 30, the conductor portion 31A is bent in the Z direction at a +Y directional end of the connector 61, whereby the insulating coating portion 31B of the coated electric wire 31 is situated on a +Z directional surface of the extension portion 72B of the sheet type conductive member 71. That is, both the insulating coating portion 31B of the coated electric wire 31 and the extension portion 72B of the sheet type conductive member 71 can extend in the +Y direction without interfering with each other in the Z direction.

Thus, also in Embodiment 3, the conductor portion 31A exposed at the conductor exposed portion P3 of the coated electric wire 31 makes contact with the electric wire connecting region 21C of the corresponding flexible conductor 21B, thereby enabling to achieve a connector assembly that is small, specifically, thin, while electrically connecting the conductor portion 31A of the coated electric wire 31 to the flexible conductor 21B exposed on the surface of the sheet type conductive member 71 with high reliability.

In addition, since the electric wire guiding hole 71E constituted of a long hole is formed to be connected to the electric wire inserting hole 71D of the sheet type conductive member 71 via the communication opening portion 71F, the conductor portion 31A of the coated electric wire 31 is passed through the electric wire guiding hole 71E and then slid along the communication opening portion 71F, whereby the conductor portion 31A can be passed through the electric wire inserting hole 71D, thus improving the operability in assembling the connector assembly.

### Embodiment 4

FIG. 31 shows a connector assembly according to Embodiment 4. The connector assembly is obtained by connecting conductor portions 31A of a plurality of coated electric wires 31 to a sheet type conductive member 71 by means of a connector 81.

The connector 81 includes a first insulator 82 and a second insulator 83 each made of an insulating resin material.

FIG. 32 shows an assembly view of the connector assembly according to Embodiment 4.

The first insulator 82 is obtained by forming a plurality of electric wire accommodating grooves 82C in which the insulating coating portions 31B of the coated electric wires 31 are accommodated, instead of the plurality of electric wire accommodating grooves 62C in which the conductor portions 31A of the coated electric wires 31 are accommodated, in the flat plate portion 62A in the first insulator 62 used in Embodiment 3, and otherwise has the same configuration as the first insulator 62 in Embodiment 3.

The second insulator 83 is obtained by forming a plurality of electric wire accommodating grooves (not shown) in which the insulating coating portions 31B of the coated electric wires 31 are accommodated, instead of the plurality of electric wire accommodating grooves in which the conductor portions 31A of the coated electric wires 31 are accommodated, in the flat plate portion 63A in the second insulator 63 used in Embodiment 3, and otherwise has the same configuration as the second insulator 63 in Embodiment 3.

The sheet type conductive member 71 herein is the same as that used in Embodiment 3.

Also in Embodiment 4, as with Embodiment 3, the coated electric wires 31 in assembling the connector assembly are each disposed in such a position as to extend in the Z direction such that the tip portion P1 faces in the -Z direction and that the base end portion P2 faces in the +Z direction. However, the insulating coating portion 31B is not removed and remains at the tip portion P1 of each coated electric wire 31, and the conductor exposed portion P3, in which the conductor portion 31A is exposed over a predetermined Z directional length by removing the insulating coating portion 31B, is formed at a position away from the tip portion P1 in the +Z direction by a predetermined distance.

When the connector assembly is assembled, as with Embodiment 3, first, the tip portion P1 of each of the coated electric wires 31 is passed through the corresponding electric wire guiding hole 71E of the sheet type conductive member 71 from the +Z direction. At this time, since the T-shaped opening is formed by connecting the communication opening portion 71F to the electric wire guiding hole 71E of the sheet type conductive member 71 as shown in FIG. 24, when the tip portion P1 of the coated electric wire 31 having the insulating coating portion 31B having the diameter larger than that of the conductor portion 31A is pressed against the electric wire guiding hole 71E, the pair of corners 71G contacting the T-shaped opening are bent so that the tip portion P1 of the coated electric wire 31 is passed through the electric wire guiding hole 71E, and the conductor portion 31A exposed at the conductor exposed portion P3 can be situated at the electric wire guiding hole 71E.

As with Embodiment 3, the conductor portion 31A of the conductor exposed portion P3 is then slid from the electric wire guiding hole 71E to the electric wire inserting hole 71D along the communication opening portion 71F, and the second sheet portion 73 of the sheet type conductive member 71 is folded back along the folding-back line L. In this manner, the tip portion P1 of each of the coated electric wires 31 projects from the sheet type conductive member 71 toward the -Y direction.

Thereafter, the bosses 12E of the first insulator 82 are passed through the through-holes 21F of the sheet type conductive member 71 from the -Z direction and further passed through the fixing holes 13E of the second insulator 83, and the first insulator 82 and the second insulator 83 are fixed to each other to form the connector 81. Thus, the assembling operation of the connector assembly shown in FIG. 31 is completed.

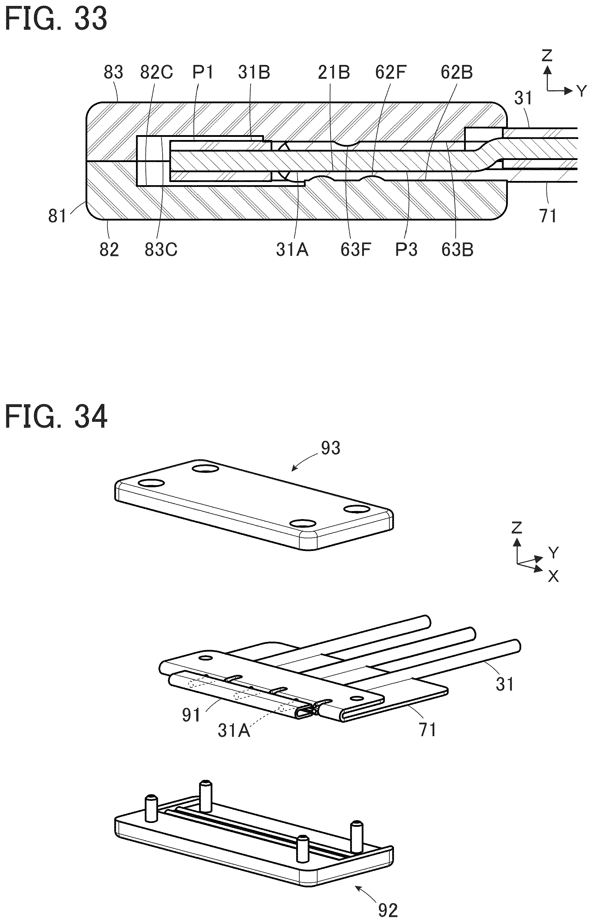

As shown in FIG. 33, as with Embodiment 3, the conductor portion 31A exposed at the conductor exposed portion P3 of the coated electric wire 31 is sandwiched between the two parts of the flexible conductor 21B thus folded. The flexible conductor 21B is then tightly attached and electrically connected to the conductor portion 31A by the ribs 62F formed on the first retaining surface 62B of the first insulator 82 and the ribs 63F formed on the second retaining surface 63B of the second insulator 83.

Similarly, the plurality of flexible conductors 21B are electrically connected separately to the conductor portions 31A of the plurality of coated electric wires 31.

The tip portion P1 of the coated electric wire 31 projecting from the sheet type conductive member 71 toward the -Y direction is accommodated in the electric wire accommodating groove 82C of the first insulator 82 and the electric wire accommodating groove 83C of the second insulator 83 in the connector 81.

Thus, also in Embodiment 4, the conductor portion 31A exposed at the conductor exposed portion P3 of the coated electric wire 31 makes contact with the electric wire connecting region 21C of the corresponding flexible conductor 21B, thereby enabling to achieve a connector assembly that is small, specifically, thin, while electrically connecting the conductor portion 31A of the coated electric wire 31 to the flexible conductor 21B exposed on the surface of the sheet type conductive member 71 with high reliability.

In addition, since the conductor portion 31A at the tip portion P1 of the coated electric wire 31 projecting from the sheet type conductive member 71 toward the -Y direction is covered with the insulating coating portion 31B, short-circuit between the conductor portions 31A of the adjacent coated electric wires 31 can be prevented. Further, even when the conductor portion 31A is formed from a so-called stranded wire constituted of plural conductors being stranded, the insulating coating portion 31B covering the tip portion P1 of the coated electric wire 31 prevents a tip of the stranded wire from spreading, so that not only short-circuit due to the spread conductors is prevented, but also the handleability of the coated electric wire 31 is improved.

Instead of covering, with the insulating coating portion 31B, the conductor portion 31A at the tip portion P1 of the coated electric wire 31 projecting from the sheet type conductive member 71 toward the -Y direction, the connector assembly may be configured such that the conductor portion 31A exposed by removing the insulating coating portion 31B projects from the sheet type conductive member 71 toward the -Y direction as the tip portion P1 and that the outer periphery of the projecting conductor portion 31A is covered with an insulating tape 91 as shown in FIG. 34; even in this configuration, short-circuit of the conductor portions 31A of the adjacent coated electric wires 31 can be prevented.

In this case, as shown in FIG. 34, it is necessary to use a first insulator 92 and a second insulator 93 each having a structure in which the conductor portions 31A covered with the insulating tape 91 can be accommodated.

While the three flexible conductors 21B exposed on the surface of the sheet type conductive member 21, 51, 71 are electrically connected to the conductor portions 31A of the three coated electric wires 31 in Embodiments 1 to 4 above, the invention is not limited thereto, and one or more flexible conductor(s) 21B can be electrically connected to a conductor portion(s) 31A of one or more coated electric wire(s) 31 in a similar manner.

While the covered electric wire 31 is used as an electric wire to be connected to the flexible conductor 21B of the sheet type conductive member 21, 51, 71 in Embodiments 1 to 4 above, an electric wire formed of only the conductor portion 31A whose outer periphery is not covered with the insulating coating portion 31B may be connected to the flexible conductor 21B of the sheet type conductive member 21, 51, 71.

## Claims

1. A connector assembly comprising:
a sheet type conductive member (21, 51, 71) having a flexible conductor (21B) exposed on a surface of the sheet type conductive member;
an electric wire (31) having a conductor portion (31A); and
a connector (11, 41, 61, 81) connecting the conductor portion to the flexible conductor,
wherein the connector includes a first insulator (12, 42, 62, 82, 92) having a first retaining surface (12B) and a second insulator (13, 43, 63, 83, 93) having a second retaining surface (13B) facing the first retaining surface,
wherein the sheet type conductive member includes a first sheet portion (22, 52, 72) having a retained portion (22A, 52A, 72A) disposed to face the first retaining surface, a second sheet portion (23, 53, 73) joined to the retained portion via a folding-back line (L) and disposed to face the second retaining surface with the second sheet portion being folded back onto the retained portion along the folding-back line, and at least one electric wire inserting hole (21D, 21E, 51D, 51E, 71D) formed in at least one of the retained portion and the second sheet portion and penetrating the sheet type conductive member,
wherein the flexible conductor is exposed at least on a surface of the retained portion,
wherein the conductor portion of the electric wire is passed through the electric wire inserting hole and disposed between the retained portion and the second sheet portion, and
wherein the first insulator and the second insulator are fixed with each other such that the retained portion and the second sheet portion are superposed on each other and disposed between the first retaining surface and the second retaining surface, whereby the flexible conductor (21B) makes contact with and is electrically connected to the conductor portion (31A) of the electric wire.

2. The connector assembly according to claim 1,
wherein the first sheet portion (22, 52, 72) has an extension portion (22B, 52B, 72B) extending from the retained portion (22A, 52A, 72A) to an outside of the connector along a predetermined direction, and
wherein the flexible conductor (21B) is disposed continuously from the retained portion to the extension portion.

3. The connector assembly according to claim 2,
wherein the sheet type conductive member (21, 51) has a pair of the electric wire inserting holes (21D, 21E, 51D, 51E) each penetrating the sheet type conductive member,
wherein the flexible conductor (21B) is disposed between the pair of the electric wire inserting holes, and
wherein the electric wire (31) is sequentially passed through the pair of the electric wire inserting holes, and the conductor portion (31A) of the electric wire situated between the pair of the electric wire inserting holes is electrically connected to the flexible conductor (21B).

4. The connector assembly according to claim 3,
wherein the flexible conductor (21B) is disposed continuously from the second sheet portion (23) to the retained portion (22A) and the extension portion (22B) beyond the folding-back line (L) and folded in two parts along the folding-back line, and
wherein the conductor portion (31A) of the electric wire situated between the pair of the electric wire inserting holes is disposed between the two parts of the flexible conductor thus folded and electrically connected to the flexible conductor (21B).

5. The connector assembly according to claim 4, wherein the pair of the electric wire inserting holes (21D, 21E) are disposed on the folding-back line (L).

6. The connector assembly according to claim 3, wherein the pair of the electric wire inserting holes (51D, 51E) are disposed within the retained portion (52A) and separately at positions inclined with respect to the folding-back line (L).

7. The connector assembly according to claim 3,
wherein a tip portion (P1) of the electric wire (31) sequentially passed through the pair of the electric wire inserting holes (21D, 21E, 51D, 51E) is accommodated between the first insulator (12, 42) and the second insulator (13, 43), and
wherein a base end portion (P2) of the electric wire (31) sequentially passed through the pair of the electric wire inserting holes extends to the outside of the connector (11, 41).

8. The connector assembly according to claim 3,
wherein the electric wire (31) has a structure in which an outer periphery of the conductor portion (31A) is covered with an insulating coating portion (31B),
wherein, between the pair of the electric wire inserting holes (21D, 21E, 51D, 51E), the insulating coating portion is removed from the electric wire so that the conductor portion (31A) is exposed, and
wherein, at a position other than between the pair of the electric wire inserting holes, an outer periphery of the conductor portion (31A) of the electric wire is covered with the insulating coating portion (31B).

9. The connector assembly according to claim 2,
wherein the sheet type conductive member (71) has the electric wire inserting hole (71D) penetrating the sheet type conductive member on the folding-back line (L) and at a position where the flexible conductor (21B) is exposed,
wherein the flexible conductor (21B) is disposed continuously from the second sheet portion to the retained portion and the extension portion beyond the folding-back line (L) and folded in two parts along the folding-back line,
wherein the electric wire (31) is passed through the electric wire inserting hole, and
wherein the conductor portion (31A) of the electric wire disposed between the two parts of the flexible conductor thus folded is electrically connected to the flexible conductor (21B).

10. The connector assembly according to claim 9,
wherein the sheet type conductive member (71) includes: an electric wire guiding hole (71E) disposed near the electric wire inserting hole and penetrating the sheet type conductive member; and a communication opening portion (71F) communicating the electric wire inserting hole and the electric wire guiding hole communicate with each other and penetrating the sheet type conductive member,
wherein the electric wire inserting hole (71D) is constituted of a round hole having a diameter (S1) corresponding to a diameter of the conductor portion of the electric wire,
wherein the electric wire guiding hole (71E) is constituted of a long hole having a width (S2) substantially equal to the diameter of the electric wire inserting hole, and
wherein the communication opening portion (71F) has an opening width (S3) having a dimension smaller than the diameter of the conductor portion of the electric wire.

11. The connector assembly according to claim 9, wherein at least one of the first retaining surface (12B) and the second retaining surface (13B) has a rib (62F, 63F) for tightly attaching the flexible conductor to the conductor portion of the electric wire.

12. The connector assembly according to claim 9,
wherein the electric wire (31) has a structure in which an outer periphery of the conductor portion (31A) is covered with an insulating coating portion (31B), and
wherein, between the two parts of the flexible conductor (21B) thus folded, the insulating coating portion is removed from the electric wire so that the conductor portion (31A) is exposed.

13. The connector assembly according to claim 12, wherein the electric wire (31) has a tip portion (P1) that projects from the electric wire inserting hole (71D) toward an outside of the sheet type conductive member (71) and that is accommodated between the first insulator (82, 92) and the second insulator (83, 93).

14. The connector assembly according to claim 13, wherein, at the tip portion (P1), the insulating coating portion is removed from the electric wire so that the conductor portion (31A) is exposed.

15. The connector assembly according to claim 13, wherein, at the tip portion (P1), an outer periphery of the conductor portion (31A) of the electric wire is covered with the insulating coating portion (31B) or an insulating tape (91).

16. The connector assembly according to claim 1, wherein a boss (12E) formed at one of the first retaining surface and the second retaining surface is inserted in a fixing hole (13E) formed at another of the first retaining surface and the second retaining surface, whereby the first insulator (12, 42, 62, 82, 92) and the second insulator (13, 43, 63, 83, 93) are fixed with each other.

17. The connector assembly according to claim 1,
wherein the sheet type conductive member (21, 51, 71) has a plurality of the flexible conductors (21B) aligned in a predetermined direction along the folding-back line (L), and
wherein the plurality of the flexible conductors (21B) are electrically connected separately to the conductor portions (31A) of a plurality of the electric wires aligned in the predetermined direction.

18. A connecting method for connecting a conductor portion (31A) of an electric wire (31) to a flexible conductor (21B) exposed on a surface of a sheet type conductive member (21, 51, 71), the method comprising:
passing the conductor portion (31A) of the electric wire through at least one electric wire inserting hole (21D, 21E, 51D, 51E, 71D) formed in at least one of a retained portion (22A, 52A, 72A) and a second sheet portion (23, 53, 73) in the sheet type conductive member having a first sheet portion (22, 52, 72) and the second sheet portion joined to the retained portion of the first sheet portion via a folding-back line (L), the at least one electric wire inserting hole penetrating the sheet type conductive member,
folding back the second sheet portion (23, 53, 73) onto the retained portion (22A, 52A, 72A) along the folding-back line so that the conductor portion (31A) of the electric wire is disposed between the retained portion and the second sheet portion, and
fixing the first insulator and the second insulator with each other with the retained portion (22A, 52A, 72A) and the second sheet portion (23, 53, 73) being sandwiched between a first retaining surface (12B) of the first insulator and a second retaining surface (13B) of the second insulator, whereby the flexible conductor (21B) makes contact with and is electrically connected to the conductor portion (31A) of the electric wire.

## Patentansprüche

1. Verbinderanordnung, umfassend:
ein flachmaterialartiges leitfähiges Element (21, 51, 71), das einen flexiblen Leiter (21B) aufweist, der an einer Fläche des flachmaterialartigen leitfähigen Elements frei liegt;
einen elektrischen Draht (31), der einen Leiterabschnitt (31A) aufweist; und
einen Verbinder (11, 41, 61, 81), der den Leiterabschnitt mit dem flexiblen Leiter verbindet,
wobei der Verbinder einen ersten Isolator (12, 42, 62, 82, 92), der eine erste Haltefläche (12B) aufweist, und einen zweiten Isolator (13, 43, 63, 83, 93), der eine zweite Haltefläche (13B) aufweist, die der ersten Haltefläche zugewandt ist, aufweist,
wobei das flachmaterialartige leitfähige Element einen ersten Flachmaterialabschnitt (22, 52, 72) aufweist, der einen gehaltenen Abschnitt (22A, 52A, 72A) aufweist, der so angeordnet ist, dass er der ersten Haltefläche zugewandt ist, einen zweiten Flachmaterialabschnitt (23, 53, 73) aufweist, der mit dem gehaltenen Abschnitt über eine Zurückfaltlinie (L) verbunden und so angeordnet ist, dass er der zweiten Haltefläche zugewandt ist, wobei der zweite Flachmaterialabschnitt entlang der Zurückfaltlinie an den gehaltenen Abschnitt zurückgefaltet ist, und wenigstens ein Einführloch (21D, 21E, 51D, 51E, 71D) für einen elektrischen Draht aufweist, das in wenigstens einem des gehaltenen Abschnitts und des zweiten Flachmaterialabschnitt gebildet ist und durch das flachmaterialartige leitfähige Element hindurch verläuft,
wobei der flexible Leiter wenigstens an einer Fläche des gehaltenen Abschnitts frei liegt,
wobei der Leiterabschnitt des elektrischen Drahtes durch das Einführloch für einen elektrischen Draht geführt und zwischen dem gehaltenen Abschnitt und dem zweiten Flachmaterialabschnitt angeordnet ist, und
wobei der erste Isolator und der zweite Isolator so aneinander befestigt sind, dass der gehaltene Abschnitt und der zweite Flachmaterialabschnitt übereinander liegen und zwischen der ersten Haltefläche und der zweiten Haltefläche angeordnet sind, wodurch der flexible Leiter (21B) mit dem Leiterabschnitt (31A) des elektrischen Drahtes in Kontakt kommt und mit diesem Leiterabschnitt (31A) elektrisch verbunden ist.

2. Verbinderanordnung nach Anspruch 1,
wobei der erste Flachmaterialabschnitt (22, 52, 72) einen Verlängerungsabschnitt (22B, 52B, 72B) aufweist, der sich von dem gehaltenen Abschnitt (22A, 52A, 72A) zu einer Außenseite des Verbinders entlang einer zuvor festgelegten Richtung erstreckt, und
wobei der flexible Leiter (21B) durchgehend von dem gehaltenen Abschnitt zu dem Verlängerungsabschnitt angeordnet ist.

3. Verbinderanordnung nach Anspruch 2,
wobei das flachmaterialartige leitfähige Element (21, 51) ein Paar der Einführlöcher (21D, 21E, 51D, 51E) für einen elektrischen Draht aufweist, die jeweils durch das flachmaterialartige leitfähige Element hindurch verlaufen, wobei der flexible Leiter (21B) zwischen dem Paar der Einführlöcher für einen elektrischen Draht angeordnet ist, und
wobei der elektrische Draht (31) nacheinander durch das Paar der Einführlöcher für einen elektrischen Draht geführt ist und der Leiterabschnitt (31A) des elektrischen Drahtes, der sich zwischen dem Paar der Einführlöcher für einen elektrischen Draht befindet, elektrisch mit dem flexiblen Leiter (21B) verbunden ist.

4. Verbinderanordnung nach Anspruch 3,
wobei der flexible Leiter (21B) durchgehend von dem zweiten Flachmaterialabschnitt (23) zu dem gehaltenen Abschnitt (22A) und dem Verlängerungsabschnitt (22B) über die Zurückfaltlinie (L) hinaus angeordnet und in zwei Teile entlang der Zurückfaltlinie gefaltet ist, und
wobei der Leiterabschnitt (31A) des elektrischen Drahtes, der sich zwischen dem Paar der Einführlöcher für den elektrischen Leiter befindet, zwischen den zwei Teilen des auf diese Weise gefalteten flexiblen Leiters angeordnet und elektrisch mit dem flexiblen Leiter (21B) verbunden ist.

5. Verbinderanordnung nach Anspruch 4, wobei das Paar der Einführlöcher (21D, 21E) für einen elektrischen Draht an der Zurückfaltlinie (L) angeordnet ist.

6. Verbinderanordnung nach Anspruch 3, wobei das Paar der Einführlöcher (51D, 51E) für einen elektrischen Draht innerhalb des gehaltenen Abschnitts (52A) und separat an Positionen angeordnet ist, die in Bezug auf die Zurückfaltlinie (L) geneigt sind.

7. Verbinderanordnung nach Anspruch 3,
wobei ein Spitzenabschnitt (P1) des elektrischen Drahtes (31), der nacheinander durch das Paar der Einführlöcher (21D, 21E, 51D, 51E) für einen elektrischen Draht geführt ist, zwischen dem ersten Isolator (12, 42) und dem zweiten Isolator (13, 43) aufgenommen ist, und
wobei sich ein Basisendabschnitt (P2) des elektrischen Drahtes (31), der nacheinander durch das Paar der Einführlöcher für einen elektrischen Draht geführt ist, zur Außenseite des Verbinders (11, 41) erstreckt.

8. Verbinderanordnung nach Anspruch 3,
wobei der elektrische Draht (31) eine Struktur aufweist, bei der ein Außenumfang des Leiterabschnitts (31A) mit einem isolierenden Beschichtungsabschnitt (31B) überzogen ist,
wobei, zwischen dem Paar der Einführlöcher (21D, 21E, 51D, 51E) für einen elektrischen Draht, der isolierende Beschichtungsabschnitt von dem elektrischen Draht entfernt ist, so dass der Leiterabschnitt (31A) frei liegt, und
wobei, an einer anderen Position als zwischen dem Paar der Einführlöcher für einen elektrischen Draht, ein Außenumfang des Leiterabschnitts (31A) des elektrischen Drahtes mit dem isolierenden Beschichtungsabschnitt (31B) überzogen ist.

9. Verbinderanordnung nach Anspruch 2,
wobei das flachmaterialartige leitfähige Element (71) das Einführloch (71D) für einen elektrischen Draht aufweist, das durch das flachmaterialartige leitfähige Element an der Zurückfaltlinie (L) und an einer Position, an der der flexible Leiter (21B) frei liegt, hindurch verläuft,
wobei der flexible Leiter (21B) durchgehend von dem zweiten Flachmaterialabschnitt zu dem gehaltenen Abschnitt und dem Verlängerungsabschnitt über die Zurückfaltlinie (L) hinaus angeordnet und in zwei Teile entlang der Zurückfaltlinie gefaltet ist,
wobei der elektrische Draht (31) durch das Einführloch für einen elektrischen Draht geführt ist, und
wobei der Leiterabschnitt (31A) des elektrischen Drahtes, der zwischen den zwei Teilen des auf diese Weise gefalteten flexiblen Leiters angeordnet ist, elektrisch mit dem flexiblen Leiter (21B) verbunden ist.

10. Verbinderanordnung nach Anspruch 9,
wobei das flachmaterialartige leitfähige Element (71) aufweist: ein Führungsloch (71E) für einen elektrischen Draht, das in der Nähe des Einführlochs für einen elektrischen Draht angeordnet ist und durch das flachmaterialartige leitfähige Element hindurch verläuft;
und einen Verbindungsöffnungsabschnitt (71F), der das Einführloch für einen elektrischen Draht und das Führungsloch für einen elektrischen Draht miteinander in Verbindung setzt und durch das flachmaterialartige leitfähige Element hindurch verläuft,
wobei das Einführloch (71D) für einen elektrischen Draht aus einem runden Loch gebildet ist, das einen Durchmesser (S1) aufweist, der einem Durchmesser des Leiterabschnitts des elektrischen Drahtes entspricht,
wobei das Führungsloch (71E) für einen elektrischen Draht aus einem Langloch gebildet ist, das eine Breite (S2) aufweist, die im Wesentlichen gleich dem Durchmesser des Einführlochs für einen elektrischen Draht ist, und
wobei der Verbindungsöffnungsabschnitt (71F) eine Öffnungsbreite (S3) aufweist, die eine Abmessung aufweist, die kleiner ist als der Durchmesser des Leiterabschnitts des elektrischen Drahtes.

11. Verbinderanordnung nach Anspruch 9, wobei wenigstens eine der ersten Haltefläche (12B) und der zweiten Haltefläche (13B) eine Rippe (62F, 63F) aufweist, um den flexiblen Leiter fest an dem Leiterabschnitt des elektrischen Drahtes anzubringen.

12. Verbinderanordnung nach Anspruch 9,
wobei der elektrische Draht (31) eine Struktur aufweist, bei der ein Außenumfang des Leiterabschnitts (31A) mit einem isolierenden Beschichtungsabschnitt (31B) überzogen ist, und
wobei, zwischen den zwei Teilen des auf diese Weise gefalteten flexiblen Leiters (21B), der isolierende Beschichtungsabschnitt von dem elektrischen Draht entfernt wird, so dass der Leiterabschnitt (31A) frei liegt.

13. Verbinderanordnung nach Anspruch 12, wobei der elektrische Draht (31) einen Spitzenabschnitt (P1) aufweist, der von dem Einführloch (71D) für einen elektrischen Draht in Richtung einer Außenseite des flachmaterialartigen leitfähigen Elements (71) vorsteht und der zwischen dem ersten Isolator (82, 92) und dem zweiten Isolator (83, 93) aufgenommen ist.

14. Verbinderanordnung nach Anspruch 13, wobei, an dem Spitzenabschnitt (P1), der isolierende Beschichtungsabschnitt von dem elektrischen Draht entfernt ist, so dass der Leiterabschnitt (31A) frei liegt.

15. Verbinderanordnung nach Anspruch 13, wobei, an dem Spitzenabschnitt (P1), ein Außenumfang des Leiterabschnitts (31A) des elektrischen Drahtes mit dem isolierenden Beschichtungsabschnitt (31B) oder einem Isolierband (91) überzogen ist.

16. Verbinderanordnung nach Anspruch 1, wobei ein Höcker (12E), der an einer der ersten Haltefläche und der zweiten Haltefläche gebildet ist, in ein Befestigungsloch (13E) eingeführt ist, das in einer anderen der ersten Haltefläche und der zweiten Haltefläche gebildet ist, wodurch der erste Isolator (12, 42, 62, 82, 92) und der zweite Isolator (13, 43, 63, 83, 93) aneinander befestigt sind.

17. Verbinderanordnung nach Anspruch 1,
wobei das flachmaterialartige leitfähige Element (21, 51, 71) mehrere der flexiblen Leiter (21B) aufweist, die in einer zuvor festgelegten Richtung entlang der Zurückfaltlinie (L) ausgerichtet sind, und
wobei die mehreren der flexiblen Leiter (21B) separat elektrisch mit den Leiterabschnitten (31A) von mehreren der elektrischen Drähte, die in der zuvor festgelegten Richtung ausgerichtet sind, verbunden sind.

18. Verbindungsverfahren zum Verbinden eines Leiterabschnitts (31A) eines elektrischen Drahtes (31) mit einem flexiblen Leiter (21B), der an einer Fläche eines flachmaterialartigen leitfähigen Elements (21, 51, 71) frei liegt, wobei das Verfahren umfasst:
Hindurchführen des Leiterabschnitts (31A) des elektrischen Drahtes durch wenigstens ein Einführloch (21D, 21E, 51D, 51E, 71D) für einen elektrischen Draht, das in wenigstens einem von einem gehaltenen Abschnitt (22A, 52A, 72A) und einem zweiten Flachmaterialabschnitt (23, 53, 73) in dem flachmaterialartigen leitfähigen Element gebildet ist, das einen ersten Flachmaterialabschnitt (22, 52, 72) und den zweiten Flachmaterialabschnitt aufweist, der mit dem gehaltenen Abschnitt des ersten Flachmaterialabschnitts über eine Zurückfaltlinie (L) verbunden wird, wobei das wenigstens eine Einführloch für einen elektrischen Draht durch das flachmaterialartige leitfähige Element hindurch verläuft,
Zurückfalten des zweiten Flachmaterialabschnitts (23, 53, 73) an den gehaltenen Abschnitt (22A, 52A, 72A) entlang der Zurückfaltlinie so, dass der Leiterabschnitt (31A) des elektrischen Drahtes zwischen dem gehaltenen Abschnitt und dem zweiten Flachmaterialabschnitt angeordnet ist, und
Befestigen des ersten Isolators und des zweiten Isolators aneinander, wobei der gehaltene Abschnitt (22A, 52A, 72A) und der zweite Flachmaterialabschnitt (23, 53, 73) zwischen einer ersten Haltefläche (12B) des ersten Isolators und einer zweiten Haltefläche (13B) des zweiten Isolators sandwichartig aufgenommen werden, wodurch der flexible Leiter (21B) mit dem Leiterabschnitt (31A) des elektrischen Drahtes in Kontakt kommt und mit diesem Leiterabschnitt (31A) elektrisch verbunden wird.

## Revendications

1. Ensemble de connecteur comprenant :
un élément conducteur de type feuille (21, 51, 71) ayant un conducteur souple (21B) exposé sur une surface de l'élément conducteur de type feuille ;
un fil électrique (31) ayant une portion de conducteur (31A) ; et
un connecteur (11, 41, 61, 81) connectant la portion de conducteur au conducteur souple,
dans lequel le connecteur inclut un premier isolant (12, 42, 62, 82, 92) ayant une première surface de retenue (12B) et un second isolant (13, 43, 63, 83, 93) ayant une seconde surface de retenue (13B) dirigée vers la première surface de retenue,
dans lequel l'élément conducteur de type feuille inclut une première portion de feuille (22, 52, 72) ayant une portion de retenue (22A, 52A, 72A) disposée de manière à faire face à la première surface de retenue, une seconde portion de feuille (23, 53, 73) assemblée à la portion de retenue par une ligne de repli (L) et disposée de manière à faire face à la seconde surface de retenue, la seconde portion de feuille étant repliée sur la portion de retenue le long de la ligne de repli, et au moins un trou d'insertion de fil électrique (21D, 21E, 51D, 51E, 71D) formé dans au moins une parmi la portion de retenue et la seconde portion de feuille et pénétrant dans l'élément conducteur de type feuille,
dans lequel le conducteur souple est exposé au moins sur une surface de la portion de retenue,
dans lequel la portion de conducteur du fil électrique est passée à travers le trou d'insertion de fil électrique et est disposée entre la portion de retenue et la seconde portion de feuille, et
dans lequel le premier isolant et le second isolant sont fixés l'un à l'autre de telle sorte que la portion de retenue et la seconde portion de feuille sont superposées l'une sur l'autre et disposées entre la première surface de retenue et la seconde surface de retenue, en sorte que le conducteur souple (21B) fait contact avec la portion de conducteur (31A) du fil électrique et est électriquement connecté à celle-ci.

2. Ensemble de connecteur selon la revendication 1,
dans lequel la première portion de feuille (22, 52, 72) a une portion d'extension (22B, 52B, 72B) s'étendant à partir de la portion de retenue (22A, 52A, 72A) jusqu'à un extérieur du connecteur le long d'une direction prédéterminée, et
dans lequel le conducteur souple (21B) est disposé en continu depuis la portion de retenue jusqu'à la portion d'extension.

3. Ensemble de connecteur selon la revendication 2,
dans lequel l'élément conducteur de type feuille (21, 51) a une paire des trous d'insertion de fil électrique (21D, 21E, 51D, 51E) pénétrant chacun dans l'élément conducteur de type feuille,
dans lequel le conducteur souple (21B) est disposé entre la paire des trous d'insertion de fil électrique, et
dans lequel le fil électrique (31) est passé séquentiellement à travers la paire des trous d'insertion de fil électrique, et la portion de conducteur (31A) du fil électrique située entre la paire des trous d'insertion de fil électrique est électriquement connectée au conducteur souple (21B).

4. Ensemble de connecteur selon la revendication 3,
dans lequel le conducteur souple (21B) est disposé en continu depuis la seconde portion de feuille (23) jusqu'à la portion de retenue (22A) et la portion d'extension (22B) au-delà de la ligne de repli (L) et est plié en deux parties le long de la ligne de repli, et
dans lequel la portion de conducteur (31A) du fil électrique située entre la paire des trous d'insertion de fil électrique est disposée entre les deux parties du conducteur souple ainsi pliées et électriquement connectées au conducteur souple (21B).

5. Ensemble de connecteur selon la revendication 4, dans lequel la paire des trous d'insertion de fil électrique (21D, 21E) sont disposés sur la ligne de repli (L).

6. Ensemble de connecteur selon la revendication 3, dans lequel la paire des trous d'insertion de fil électrique (51D, 51E) sont disposés à l'intérieur de la portion de retenue (52A) et séparément à des positions inclinées par rapport à la ligne de repli (L).

7. Ensemble de connecteur selon la revendication 3,
dans lequel une portion d'embout (P1) du fil électrique (31) passé séquentiellement à travers la paire des trous d'insertion de fil électrique (21D, 21E, 51D, 51E) est reçue entre le premier isolant (12, 42) et le second isolant (13, 43), et
dans lequel une portion d'extrémité de base (P2) du fil électrique (31) passé séquentiellement à travers la paire des trous d'insertion de fil électrique s'étend jusqu'à l'extérieur du connecteur (11, 41).

8. Ensemble de connecteur selon la revendication 3,
dans lequel le fil électrique (31) a une structure dans laquelle une périphérie extérieure de la portion de conducteur (31A) est recouverte d'une portion de revêtement d'isolation (31B),
dans lequel, entre la paire des trous d'insertion de fil électrique (21D, 21E, 51D, 51E), la portion de revêtement d'isolation est retirée du fil électrique de sorte que la portion de conducteur (31A) est exposée, et
dans lequel, à une position autre qu'entre la paire des trous d'insertion de fil électrique, une périphérie extérieure de la portion de conducteur (31A) du fil électrique est recouverte de la portion de revêtement d'isolation (31B).

9. Ensemble de connecteur selon la revendication 2,
dans lequel l'élément conducteur de type feuille (71) a le trou d'insertion de fil électrique (71D) pénétrant dans l'élément conducteur de type feuille sur la ligne de repli (L) et à une position où le conducteur souple (21B) est exposé,
dans lequel le conducteur souple (21B) est disposé en continu depuis la seconde portion de feuille jusqu'à la portion de retenue et la portion d'extension au-delà de la ligne de repli (L) et est plié en deux parties le long de la ligne de repli,
dans lequel le fil électrique (31) est passé à travers le trou d'insertion de fil électrique, et
dans lequel la portion de conducteur (31A) du fil électrique disposée entre les deux parties du conducteur souple ainsi plié est électriquement connectée au conducteur souple (21B).

10. Ensemble de connecteur selon la revendication 9,
dans lequel l'élément conducteur de type feuille (71) inclut :
un trou de guidage de fil électrique (71E) disposé près du trou d'insertion de fil électrique et pénétrant dans l'élément conducteur de type feuille ; et une portion d'ouverture de communication (71F) faisant communiquer le trou d'insertion de fil électrique et le trou de guidage de fil électrique l'un avec l'autre et pénétrant dans l'élément conducteur de type feuille,
dans lequel le trou d'insertion de fil électrique (71D) est constitué d'un trou rond ayant un diamètre (S1) correspondant à un diamètre de la portion de conducteur du fil électrique,
dans lequel le trou de guidage de fil électrique (71E) est constitué d'un trou long ayant une largeur (S2) sensiblement égale au diamètre du trou d'insertion de fil électrique, et
dans lequel la portion d'ouverture de communication (71F) a une largeur d'ouverture (S3) ayant une dimension plus petite que le diamètre de la portion de conducteur du fil électrique.

11. Ensemble de connecteur selon la revendication 9, dans lequel au moins une parmi la première surface de retenue (12B) et la seconde surface de retenue (13B) a une nervure (62F, 63F) pour fixer de manière serrée le conducteur souple à la portion de conducteur du fil électrique.

12. Ensemble de connecteur selon la revendication 9,
dans lequel le fil électrique (31) a une structure dans laquelle une périphérie extérieure de la portion de conducteur (31A) est recouverte d'une portion de revêtement d'isolation (31B), et
dans lequel, entre les deux parties du conducteur souple (21B) ainsi plié, la portion de revêtement d'isolation est retirée du fil électrique de sorte que la portion de conducteur (31A) est exposée.

13. Ensemble de connecteur selon la revendication 12, dans lequel le fil électrique (31) a une portion d'embout (P1) qui fait saillie à partir du trou d'insertion de fil électrique (71D) vers un extérieur de l'élément conducteur de type feuille (71) et qui est reçue entre le premier isolant (82, 92) et le second isolant (83, 93).

14. Ensemble connecteur selon la revendication 13, dans lequel, sur la portion d'embout (P1), la portion de revêtement d'isolation est retirée du fil électrique de sorte que la portion de conducteur (31A) est exposée.

15. Ensemble de connecteur selon la revendication 13, dans lequel, sur la portion d'embout (P1), une périphérie extérieure de la portion de conducteur (31A) du fil électrique est recouverte de la portion de revêtement d'isolation (31B) ou d'un ruban isolant (91).

16. Ensemble de connecteur selon la revendication 1, dans lequel un bossage (12E) formé sur une parmi la première surface de retenue et la seconde surface de retenue est inséré dans un trou de fixation (13E) formé sur une autre parmi la première surface de retenue et la seconde surface de retenue, en sorte que le premier isolant (12, 42, 62, 82, 92) et le second isolant (13, 43, 63, 83, 93) sont fixés l'un à l'autre.

17. Ensemble de connecteur selon la revendication 1,
dans lequel l'élément conducteur de type feuille (21, 51, 71) a une pluralité des conducteurs souples (21B) alignés dans une direction prédéterminée le long de la ligne de repli (L), et
dans lequel la pluralité des conducteurs souples (21B) sont électriquement connectée séparément aux portions de conducteur (31A) d'une pluralité des fils électriques alignés dans la direction prédéterminée.

18. Procédé de connexion pour connecter une portion de conducteur (31A) d'un fil électrique (31) à un conducteur souple (21B) exposé sur une surface d'un élément conducteur de type feuille (21, 51, 71), le procédé comprenant de :
faire passer la portion de conducteur (31A) du fil électrique à travers au moins un trou d'insertion de fil électrique (21D, 21E, 51D, 51E, 71D) formé dans au moins une parmi une portion de retenue (22A, 52A, 72A) et une seconde portion de feuille (23, 53, 73) dans l'élément conducteur de type feuille ayant une première portion de feuille (22, 52, 72) et la seconde portion de feuille assemblée à la portion de retenue de la première portion de feuille via une ligne de repli (L), le au moins un trou d'insertion de fil électrique pénétrant dans l'élément conducteur de type feuille,
replier la seconde portion de feuille (23, 53, 73) sur la portion de retenue (22A, 52A, 72A) le long de la ligne de repli de sorte que la portion de conducteur (31A) du fil électrique est disposée entre la portion de retenue et la seconde portion de feuille, et
fixer le premier isolant et le second isolant l'un avec l'autre, la portion de retenue (22A, 52A, 72A) et la seconde portion de feuille (23, 53, 73) étant prises en sandwich entre une première surface de retenue (12B) du premier isolant et une seconde surface de retenue (13B) du second isolant, en sorte que le conducteur souple (21B) fait contact et est électriquement connecté à la portion de conducteur (31A) du fil électrique.
